(19) Europäisches Patentamt / European Patent Office / Office européen des brevets

(11) **EP 3 726 183 B1**

(12) **FASCICULE DE BREVET EUROPEEN**

(45) Date de publication et mention
de la délivrance du brevet:
**15.12.2021 Bulletin 2021/50**

(51) Int Cl.:
*G01C 17/38* *(2006.01)*    *G01C 21/16* *(2006.01)*
*G01C 25/00* *(2006.01)*    *G01R 33/00* *(2006.01)*
*G01R 33/02* *(2006.01)*

(21) Numéro de dépôt: **20169161.5**

(22) Date de dépôt: **10.04.2020**

(54) **PROCÉDÉ DE DÉTERMINATION DE LA POSITION ET DE L'ORIENTATION D'UN VÉHICULE**

VERFAHREN ZUR POSITIONSBESTIMMUNG UND ORIENTIERUNG EINES FAHRZEUGS

METHOD FOR DETERMINING THE POSITION AND ORIENTATION OF A VEHICLE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.04.2019 FR 1904015**

(43) Date de publication de la demande:
**21.10.2020 Bulletin 2020/43**

(73) Titulaire: **Commissariat à l'énergie atomique
et aux énergies alternatives
75015 Paris (FR)**

(72) Inventeur: **VILLIEN, Christophe
38054 GRENOBLE Cedex 9 (FR)**

(74) Mandataire: **INNOV-GROUP
310, avenue Berthelot
69372 Lyon Cedex 08 (FR)**

(56) Documents cités:
EP-A1- 1 719 975    EP-A1- 3 276 302
WO-A1-2014/134710    US-A1- 2011 238 307

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne un procédé et un système de détermination de la position et de l'orientation d'un véhicule. Elle a également pour objet un procédé et un module de calibration d'un magnétomètre pour la mise en œuvre du procédé de détermination de la position et de l'orientation du véhicule. Elle a aussi pour objet un support d'enregistrement d'informations pour la mise en œuvre du procédé de calibration.

Des procédés connus de détermination de la position et de l'orientation d'un véhicule comportent :

- la fourniture d'un système de localisation fixé sur ce véhicule, ce système de localisation comportant :

    • une unité de géolocalisation par satellite,
    • une unité de navigation inertielle contenant un accéléromètre et un gyromètre, et
    • un magnétomètre comportant au moins deux axes de mesure,

- la mesure, par le magnétomètre, d'un premier vecteur de mesures brutes contenant une composante brute pour chacun des axes de mesure, chaque composante codant l'amplitude et la direction de la projection orthogonale du champ magnétique qui traverse ce magnétomètre sur un axe respectif de mesure, ces axes de mesure étant fixes dans un repère mobile tri-axe fixé sur le véhicule, puis
- la correction de chacune des composantes brutes du premier vecteur en la multipliant par un coefficient d'échelle et en y ajoutant un coefficient de décalage pour obtenir une composante corrigée, ces coefficients d'échelle et de décalage étant obtenus à partir de données pré-enregistrées dans une mémoire du système de localisation, puis
- une estimation initiale de l'angle de lacet du véhicule à partir des composantes corrigées du premier vecteur, puis
- l'initialisation, à l'aide de l'estimation initiale de l'angle de lacet, d'un algorithme de fusion apte à établir, à partir de précédentes estimations de la position et de l'orientation du véhicule et en utilisant à la fois les mesures de l'unité de géolocalisation et les mesures de l'unité de navigation inertielle réalisées depuis ces précédentes estimations :

    • de nouvelles estimations de la position et de l'orientation du véhicule, et
    • une marge d'erreur sur cette nouvelle estimation de l'orientation du véhicule, puis

- l'exécution répétée, pendant toute une phase d'utilisation, de cet algorithme de fusion pour mettre à jour en continu l'estimation de la position et de l'orientation du véhicule.

De tels procédés sont, par exemple, décrits en détail dans le livre suivant et en particulier, dans les chapitres 5.6 et 15 : Paul D. Groves : "Principles of GNSS, Inertial, and Multisensor Integrated Navigation Systems", Second Edition (GNSS Technology and Applications), Artech House, 2008.

De l'état de la technique est également connu de EP1719975A1, WO2014/134710A1, US2011/238307A1 et EP3276302A1.

L'utilisation d'un magnétomètre pour obtenir l'estimation initiale de l'angle de lacet du véhicule pose cependant quelques problèmes. L'estimation initiale de l'angle de lacet doit être fournie au démarrage du système et être la plus précise possible. En effet, plus l'estimation initiale de l'angle de lacet est mauvaise, plus la convergence de l'algorithme de fusion vers une estimation précise de la position et de l'orientation du véhicule est lente.

Or, la calibration du magnétomètre varie au cours du temps de sorte que des valeurs des coefficients d'échelle et de décalage qui étaient un temps appropriées pour corriger correctement le premier vecteur de mesures ne le sont plus plus tard. Ainsi, au fur et à mesure du temps, la précision de l'estimation initiale de l'angle de lacet se dégrade.

De plus, la calibration d'un magnétomètre alors qu'il est déjà monté dans un véhicule qui se déplace est difficile à réaliser. En effet, dans cette situation, l'environnement extérieur du magnétomètre n'est pas maîtrisé et n'est pas connu.

L'invention vise à proposer un tel procédé de détermination de la position et de l'orientation d'un véhicule dans lequel la précision de l'estimation initiale de l'angle de lacet est améliorée.

Elle a donc pour objet un tel procédé conforme à la revendication 1.

Les modes de réalisation de ce procédé de détermination de la position et de l'orientation d'un véhicule peuvent comporter une ou plusieurs des caractéristiques des revendications dépendantes.

L'invention a également pour objet un support d'enregistrement d'informations, lisible par un microprocesseur et comportant des instructions pour la réalisation d'une phase de calibration du procédé revendiqué, lorsque ces instructions sont exécutées par le microprocesseur.

L'invention a aussi pour objet un système de localisation conforme à la revendication 10.

L'invention sera mieux comprise à la lecture de la description qui va suivre, donnée uniquement à titre d'exemple non limitatif et faite en se référant aux dessins sur lesquels :

- la figure 1 est une illustration schématique d'un système de localisation d'un véhicule ;
- la figure 2 est un organigramme d'un procédé de détermination de la position et de l'orientation d'un véhicule à l'aide du système de la figure 1 ;
- la figure 3 est un organigramme d'un procédé d'estimation de coefficients d'échelle et de décalage pour la calibration d'un magnétomètre mis en œuvre dans le procédé de la figure 2.

Dans ces figures, les mêmes références sont utilisées pour désigner les mêmes éléments.

Dans la suite de cette description, les caractéristiques et fonctions bien connues de l'homme du métier ne sont pas décrites en détail. En particulier, pour les connaissances générales de l'homme du métier concernant les systèmes de localisation d'un véhicule à l'aide d'une unité de géolocalisation par satellite et d'une unité de navigation inertielle, il est renvoyé au livre de Monsieur Groves précédemment cité.

Chapitre I : Exemples de mode de réalisation

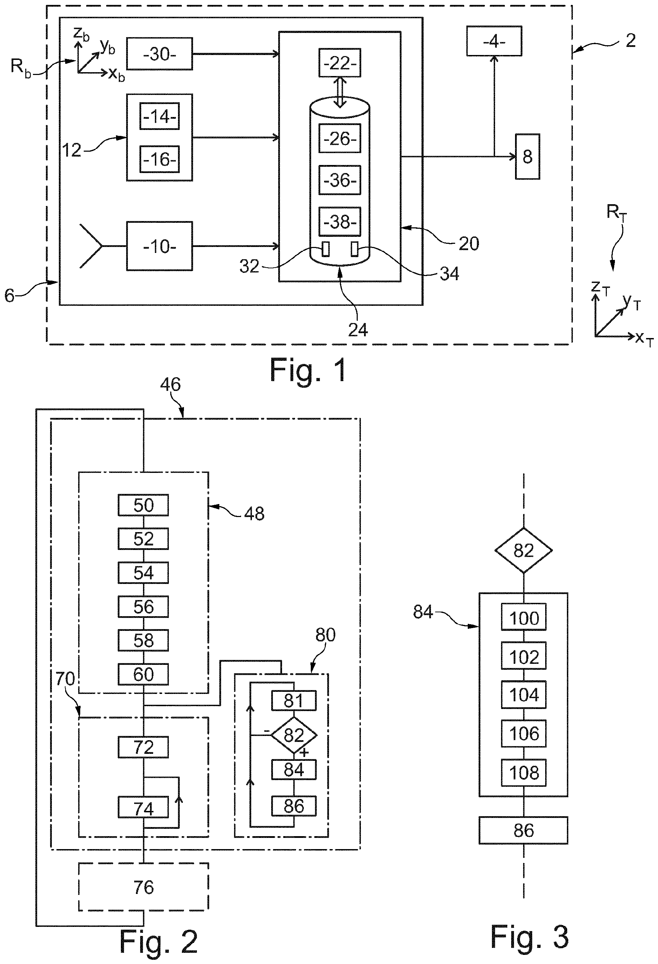

La figure 1 représente un véhicule 2 capable de se déplacer sur la terre, sur la mer ou dans les airs. Le véhicule 2 peut donc être un véhicule automobile, un train, un bateau, un avion ou tout autre véhicule similaire. Le véhicule 2 est équipé de moyens 4 de propulsion.

Le véhicule 2 est aussi équipé d'un système 6 de localisation de ce véhicule. Ce système 6 est apte à déterminer de la position et de l'orientation du véhicule 2 dans un repère terrestre $R_T$. Le repère terrestre $R_T$ est fixé sans aucun degré de liberté à la terre. Le repère $R_T$ comporte trois axes typiquement orthogonaux entre eux. Un repère mobile $R_b$ est également fixé sans aucun degré de liberté au véhicule 2. Ce repère $R_b$ comporte trois axes orthogonaux entre eux notés respectivement $x_b$, $y_b$ et $z_b$. Classiquement, lorsque le véhicule 2 se déplace horizontalement, les axes $x_b$ et $y_b$ sont dans un plan horizontal et l'axe $z_b$ est vertical.

Ici, la position du véhicule 2 dans le repère $R_T$ est exprimée par la latitude L, la longitude $\lambda$ et l'altitude h de l'origine du repère $R_b$.

L'orientation du véhicule 2 est exprimée par l'angle $\psi$ de lacet (« yaw angle » en anglais), l'angle $\theta$ de tangage (« pitch angle » en anglais) et l'angle $\Phi$ de roulis (« roll angle » en anglais) du repère $R_b$ par rapport au repère $R_T$.

La position et l'orientation déterminées par le système 6 sont généralement transmises à un poste 8 de pilotage pour guider ou assister au guidage du véhicule 2 vers une destination prédéfinie. Le poste 8 peut être un poste de pilotage manuel et/ou automatique. Dans le cas d'un poste de pilotage manuel, la position et l'orientation déterminées sont transmises à une interface homme-machine pour assister un être humain dans le pilotage des moyens 4 de propulsion. Dans le cas d'un poste de pilotage automatique, la position et l'orientation déterminées sont automatiquement converties en commandes de pilotage des moyens 4 de propulsion, puis transmises automatiquement à ces moyens 4 de propulsion.

Le système 6 comporte une unité 10 de géolocalisation par satellite et une unité 12 de navigation inertielle. L'unité 10 est connue sous l'acronyme GNSS (« Global Navigation Satellite System ». L'unité 10 est ici une unité de géolocalisation mono-antenne et non pas une unité de géolocalisation multi-antenne. L'unité 10 est donc incapable de mesurer l'orientation absolue du véhicule 2 dans le repère $R_T$ à partir des signaux émis par les satellites.

L'unité 12 est connue sous l'acronyme INS (« Inertial Navigation System ». L'unité 12 comporte notamment un accéléromètre triaxe 14 et un gyromètre triaxe 16. Grâce à ces capteurs, l'unité 12 est capable de mesurer la variation de l'orientation du véhicule 2. Par contre, l'unité 12 est incapable elle aussi de mesurer directement l'orientation du véhicule 2 dans le repère $R_T$.

Pour déterminer la position et l'orientation du véhicule 2 à partir des mesures des unités 10 et 12, le système 6 comporte un calculateur électronique programmable 20. Ce calculateur 20 est apte à acquérir les mesures des unités 10 et 12 et, à partir de ces mesures, à déterminer la position et l'orientation du véhicule 2 dans le repère $R_T$. Le calculateur 20 comporte un microprocesseur 22 et une mémoire 24 comportant les instructions et les données nécessaires à la mise en œuvre des procédés décrits en référence aux figures 2 et 3.

Plus précisément, la mémoire 24 comporte les instructions d'un module 26. Le module 26 exécute notamment un algorithme de fusion apte à établir, à partir d'une précédente estimation de la position et de l'orientation du véhicule 2 et de nouvelles mesures des unités 10 et 12 acquises depuis cette précédente estimation, une nouvelle estimation de la position et de l'orientation du véhicule 2. L'algorithme de fusion établit également pour chaque nouvelle estimation de la position et de l'orientation du véhicule 2, une marge d'erreur sur cette estimation.

Les algorithmes de fusion sont bien connus de l'homme du métier. Par exemple, le lecteur intéressé peut encore une fois se référer au livre de Groves précédemment cité. L'algorithme de fusion réalise la fusion des mesures des unités 10 et 12 pour obtenir des estimations de la position et de l'orientation du véhicule 2 plus précises qui si, par exemple, seules les mesures de l'unité 10 étaient utilisées pour déterminer la position et seules les mesures de l'unité 12 étaient utilisées pour déterminer l'orientation du véhicule 2. Autrement dit, pour établir chacune des estimations de la position et de l'orientation du véhicule 2, le module 26 utilise les mesures à la fois de l'unité 10 et de l'unité 12. Par exemple, cet algorithme de fusion est implémenté sous la forme d'un filtre de Kalman.

Comme indiqué dans l'introduction de la présente demande, il est nécessaire d'initialiser l'algorithme de fusion avec des estimations initiales de la position et de l'orientation du véhicule 2. Ces estimations initiales sont réalisées, par exemple, comme décrit dans le livre de Groves. Ici, l'estimation initiale de l'angle de lacet est obtenue à partir des mesures d'un magnétomètre. A cet effet, le système 6 comporte donc en plus un magnétomètre 30 raccordé au calculateur 20.

Le magnétomètre 30 est un magnétomètre triaxe, c'est-à-dire qu'il comporte trois axes de mesure non colinéaires, fixes dans le repère $R_b$. Ici, ces trois axes de mesure sont parallèles, respectivement, aux trois axes $x_b$, $y_b$ et $z_b$ du repère $R_b$. Chaque mesure du champ magnétique réalisée par ce magnétomètre 30 comprend trois composantes codant chacune l'amplitude et la direction de la projection orthogonale, sur un axe de mesure respectif, du champ magnétique qui traverse le magnétomètre 30 au moment où la mesure est réalisée. Le groupe formé par les trois composantes mesurées par le magnétomètre 30 est appelé par la suite « vecteur de mesure brute » et noté $B_{raw}$.

Dès sa fabrication ou dès son insertion dans le véhicule 2, les mesures du magnétomètre 30 peuvent être perturbées. Ainsi, même lors de sa première utilisation, il peut arriver que les mesures du magnétomètre 30 soient assez imprécises. Pour améliorer la précision des mesures fournies par le magnétomètre 30, notamment lors de sa première utilisation, la mémoire 24 comporte des valeurs 32 par défaut pour des coefficients d'échelle et de décalage utilisés pour corriger les composantes brutes du vecteur $B_{raw}$. Ici, par exemple, ces valeurs par défaut ne sont jamais mises à jour au cours de l'utilisation du magnétomètre 30.

La mémoire 24 comporte aussi des données pré-enregistrées utilisées pour corriger les composantes brutes du vecteur $B_{raw}$. Ici, ces données pré-enregistrées sont des valeurs courantes 34 pour les coefficients d'échelle et de décalage. Contrairement aux valeurs 32 par défaut, les valeurs courantes 34 sont régulièrement mises à jour lors de l'utilisation du magnétomètre 30 de manière à les adapter en permanence au contexte dans lequel le magnétomètre 30 est utilisé. Ainsi, au cours de l'utilisation du magnétomètre 30, le vecteur $B_{raw}$ est de préférence corrigé à l'aide des valeurs courantes 34 plutôt qu'à l'aide des valeurs 32 par défaut. Le vecteur obtenu après la correction des composantes brutes du vecteur $B_{raw}$ est appelé «vecteur de mesure corrigé» et noté $B_C$. Les composantes du vecteur $B_C$ sont appelées "composantes corrigées".

Pour mettre à jour les valeurs courantes 34, la mémoire 24 comporte également les instructions d'un module 36 de calibration du magnétomètre 30.

La mémoire 24 comporte aussi un modèle préenregistré 38 du champ géomagnétique. Le modèle 38 associe à chaque position susceptible d'être occupée par le véhicule 2, les trois composantes du champ géomagnétique présent à cette position. Le groupe formé par les trois composantes du champ géomagnétique est appelé par la suite « vecteur de référence » et noté $B_0$. Chacune des composantes du vecteur $B_0$ code l'amplitude et la direction de la projection orthogonale, sur un axe respectif du repère $R_T$, du champ géomagnétique. Par exemple, le modèle 38 est le modèle connu sous l'acronyme IGRF (« International Geomagnetic Reference Field »).

L'utilisation du système 6 se décompose en périodes successives d'activité séparées les unes des autres par des périodes d'inactivité. Pendant les périodes d'inactivité, le système 6 n'est pas actif, c'est-à-dire qu'il ne détermine pas la position et l'orientation du véhicule 2. Typiquement, pendant les périodes d'inactivité, les unités 10 et 12 et le magnétomètre 30 ne réalisent aucune mesure et ne transmettent aucune mesure au calculateur 20. Le calculateur 20 n'exécute donc aucun traitement sur ces mesures. Ces périodes d'inactivité durent généralement plusieurs minutes ou plusieurs heures ou plusieurs jours. Par contre, pendant ces périodes d'inactivité, les valeurs courantes 34 des coefficients d'échelle et de décalage estimées lors d'une précédente période d'activité sont conservées dans la mémoire 24. A cet effet, la mémoire 24 est une mémoire non volatile.

Par exemple, pendant les périodes d'inactivité, le système 6 est éteint ou en veille.

A l'inverse, pendant chaque période d'activité, les unités 10 et 12 et le magnétomètre 30 délivrent des nouvelles mesures au calculateur 20 qui les traite pour déterminer la position et l'orientation du véhicule 2 en fonction de ces nouvelles mesures. Ces périodes d'activité s'enchaînent successivement les unes après les autres et sont chacune séparées l'une de l'autre par une période d'inactivité plus ou moins longue.

La figure 2 représente une période 46 d'activité.

La période 46 débute par une phase 48 d'initialisation du système 6. Cette phase 48 débute immédiatement après l'activation du système 6, c'est-à-dire typiquement juste après qu'il ait été mis sous tension. Au début de la phase 48, lors d'une opération 50, le calculateur 20 teste si la valeur d'un indicateur $I_{CF}$ est supérieure ou égale à un. La valeur de cet indicateur $I_{CF}$ est enregistrée dans la mémoire 24. Si la valeur de l'indicateur $I_{CF}$ est inférieure à un, lors des opérations suivantes, les valeurs 32 par défaut des coefficients d'échelle et de décalage sont utilisées pour corriger le vecteur $B_{raw}$. A l'inverse, si la valeur de l'indicateur $I_{CF}$ est supérieure ou égale à un, lors des opérations suivantes, ce sont les valeurs courantes 34 qui sont utilisées pour corriger le vecteur $B_{raw}$.

Lors de la première période d'activité du système 6, la valeur de l'indicateur $I_{CF}$ est nulle.

Ensuite, le calculateur 20 réalise une estimation initiale de l'orientation du véhicule 2 ainsi que, éventuellement, une estimation d'autres paramètres. A titre d'exemple d'autres paramètres, le calculateur 20 peut estimer des coefficients d'échelle et de décalage pour d'autres capteurs du système 6 comme pour les capteurs 14 et 16. Par la suite, seul un exemple de mode de réalisation pour estimer l'orientation initiale du véhicule 2 est décrit.

Lors d'une opération 52, le magnétomètre 30 mesure le champ magnétique qui le traverse et délivre un premier vecteur $B_{raw}$ au calculateur 20.

Ensuite, lors d'une opération 54, le calculateur 20 corrige le vecteur $B_{raw}$ pour obtenir un premier vecteur corrigé $B_C$. Lors de cette opération, chaque composante du vecteur $B_C$ est obtenue en multipliant la composante du vecteur $B_{raw}$ mesurée pour le même axe de mesure par le coefficient d'échelle associé à cet axe de mesure et en y ajoutant le coefficient de décalage associé au même axe de mesure. Un exemple de formule pour obtenir le vecteur $B_C$ à partir du vecteur $B_{raw}$ est donné par la suite par la relation 3). Le vecteur $B_C$, comme le vecteur $B_{raw}$, est exprimé dans le repère $R_b$.

Les valeurs des coefficients d'échelle et de décalage utilisées lors de cette opération 54 sont soit les valeurs par défaut 32, soit les valeurs courantes 34 selon le résultat du test réalisé lors de l'opération 50.

Lors d'une opération 56, l'unité 10 mesure la position du véhicule 2 dans le repère $R_T$. Lors de l'opération 56, pour cela, l'unité 10 fournit une estimation initiale de la position du véhicule 2 dans le repère $R_T$, par exemple, sans utiliser les mesures de l'unité 12 et du magnétomètre 30.

Ensuite, lors d'une opération 58, le vecteur $B_0$ correspondant à la position initiale mesurée lors de l'opération 56 est obtenue en utilisant le modèle 38. On notera que lors de l'opération 56, il n'est pas nécessaire d'utiliser l'algorithme de fusion. En effet, étant donné que le champ géomagnétique varie assez lentement à la surface de la terre, à ce stade, une connaissance approximative de la position du véhicule 2 avec, par exemple, une marge d'erreur inférieure à 50 km ou 100 km ou 1000 km, est suffisante pour obtenir une estimation précise du vecteur $B_0$. Typiquement, la précision sur l'estimation de la position initiale par l'unité 10 est très inférieure à 50 km. Par exemple, elle est généralement inférieure à 50 m ou 10 m.

Lors d'une opération 60, l'estimation initiale de l'angle de lacet est construite à partir du vecteur $B_C$ obtenu à l'issue de l'opération 54. En effet, les vecteurs $B_C$ et $B_0$ correspondent au même champ géomagnétique mais exprimé dans, respectivement, les repères $R_b$ et $R_T$. Il est donc possible de déterminer l'angle de lacet du véhicule 2 et donc du repère $R_b$ par rapport au repère $R_T$, à partir de l'angle que fait le vecteur $B_C$ avec les axes du repère $R_b$.

Une fois la phase 48 d'initialisation terminée, une phase 70 d'utilisation du système 6 débute. Lors de la phase 70, le module 26 estime de façon répétée la position et l'orientation du véhicule 2 en réitérant, par exemple à intervalle régulier, l'exécution de l'algorithme de fusion. Cette phase 70 dure alors jusqu'à la fin de la période 46 d'activité et donc jusqu'au début d'une prochaine période 76 d'inactivité.

Au début de la phase 70, lors d'une opération 72, l'algorithme de fusion est initialisé. L'initialisation de l'algorithme de fusion consiste notamment à charger des valeurs initiales pour la position et l'orientation du véhicule 2. Ces valeurs initiales servent comme point de départ à cet algorithme de fusion pour ensuite établir, avec plus de précision, cette position et cette orientation du véhicule 2. Les valeurs initiales chargées lors de l'opération 72 sont celles obtenues à l'issue de la phase 48 d'initialisation. En particulier, l'angle de lacet est initialisé à l'aide de la valeur obtenue à l'issue de l'opération 60.

Ensuite, lors d'une opération 74, l'algorithme de fusion est exécuté de façon répétée par le module 26. Plus précisément, à chaque fois que des nouvelles mesures de l'unité 10 et/ou de l'unité 12 sont acquises par le calculateur 20, l'algorithme de fusion est exécuté pour mettre à jour l'estimation de la position et de l'orientation du véhicule 2.

Plus précisément, à chaque exécution de l'algorithme de fusion, le module 26 établit :

- des nouvelles estimations de la position et de l'orientation du véhicule 2, et
- des marges d'erreur sur ces nouvelles estimations de la position et de l'orientation.

Ces nouvelles estimations de la position et de l'orientation du véhicule 2 et les marges d'erreur correspondantes sont établies à partir des précédentes estimations de la position et de l'orientation du véhicule 2, des précédentes marges d'erreur établies et des nouvelles mesures des unités 10 et 12. Dans ce mode de réalisation, pendant l'opération 74, les mesures du magnétomètre 30 ne sont pas utilisées.

La marge d'erreur ou la précision sur la nouvelle estimation de l'orientation est ici donnée par les valeurs de trois écart-types notés, respectivement, $\sigma_\psi$, $\sigma_\theta$ et $\sigma_\varphi$. Les écart-types $\sigma_\psi$, $\sigma_\theta$ et $\sigma_\varphi$ correspondent aux écart-types sur les estimations, respectivement, de l'angle de lacet $\psi$, de l'angle de tangage $\theta$ et de l'angle de roulis $\varphi$.

Classiquement, le début de la phase d'utilisation est souvent appelé "phase d'alignement". Typiquement, la phase d'alignement commence avec le début de l'exécution de l'algorithme de fusion et se termine quand les précisions sur les estimations des angles de lacet $\psi$, de tangage $\theta$ et de roulis $\varphi$ sont suffisantes.

Les répétitions de l'opération 74 prennent fin uniquement quand la période 46 d'activité actuelle s'achève et que débute la nouvelle période 76 d'inactivité. Par exemple, la répétition des opérations 74 s'achève lorsque le système 6 est éteint.

Il est connu que la plus grande difficulté lors de la phase 50 est d'obtenir une estimation précise de l'angle de lacet du véhicule 2. En effet, il existe déjà des algorithmes qui permettent d'obtenir rapidement une estimation initiale des angles de roulis et de tangage ainsi que des autres paramètres souhaités. Classiquement, l'estimation initiale des angles de roulis et de tangage est, par exemple, obtenue à partir des mesures de l'accéléromètre 14. Dans le système 6, pour obtenir une estimation initiale et fiable de l'angle de lacet, les opérations suivantes sont exécutées

En parallèle de la phase 70, le module 36 exécute une phase 80 de calibration du magnétomètre 30. La phase 80 peut débuter dès que le vecteur $B_0$ a été obtenu et que le module 26 a établi une estimation de l'orientation du véhicule 2. La phase 80 a pour but d'améliorer la calibration du magnétomètre 30, c'est-à-dire d'améliorer les valeurs courantes 34 des coefficients d'échelle et de décalage pour que, lors de la prochaine exécution de l'opération 54, le vecteur $B_C$ obtenu soit plus précis que si les valeurs 32 par défaut avaient été utilisées. En effet, même après sa fabrication et son installation dans le système 6, le magnétomètre 30 est souvent exposé à de nombreux événements extérieurs qui modifient temporairement ou définitivement son fonctionnement. Ainsi, au cours du temps, les valeurs 32 par défaut deviennent moins bonnes et il est possible de déterminer de nouvelles valeurs courantes qui permettent une meilleure correction du vecteur $B_{raw}$ et donc l'obtention d'un vecteur $B_C$ plus juste.

Ici, la phase 80 débute par une étape 81 de mesure du champ magnétique par le magnétomètre 30 et d'acquisition du vecteur $B_{raw}$ par le calculateur 20. Ensuite, lors des étapes suivantes, le vecteur $B_{raw}$ mentionné correspond au vecteur $B_{raw}$ mesuré et acquis lors de cette étape 81. Lors de cette étape 81, le module 36 acquière également l'estimation de l'orientation du véhicule 2 et la marge d'erreur sur cette estimation établie lors de l'itération la plus récente de l'opération 74.

La phase 80 se poursuit par une étape 82 lors de laquelle différentes conditions sont testées afin de s'assurer que le système 6 se trouve bien dans une situation où la mise à jour des valeurs courantes 34 des coefficients d'échelle et de décalage permettra d'obtenir de nouvelles valeurs courantes qui, si elles étaient immédiatement utilisées lors d'une opération 54, permettraient d'obtenir une estimation initiale de l'angle de lacet plus précise :

- que si les valeurs 32 par défaut étaient utilisées, et
- que si les valeurs courantes 34 n'avaient pas été mises à jour.

Dans ce mode de réalisation, à cet effet, quatre tests, appelés respectivement test 1), test 2), test 3) et test 4), sont réalisés lors de l'étape 82.

Le test 1) consiste à vérifier que la précision sur l'estimation actuelle de l'orientation du véhicule 2 est suffisamment précise. En effet, les valeurs des angles de lacet, de tangage et de roulis estimés par l'algorithme de fusion sont utilisés lors de la mise à jour des coefficients d'échelle et de décalage. Dès lors, si la précision sur les estimations de ces angles n'est pas assez bonne, cela peut dégrader la calibration du magnétomètre 30 au lieu de l'améliorer. Or, l'algorithme de fusion peut mettre un certain temps avant de fournir une estimation fiable de l'orientation du véhicule 2. Ainsi, il est important d'attendre que l'orientation du véhicule 2 soit estimée avec suffisamment de précision avant de déterminer de nouvelles valeurs courantes 34 pour les coefficients d'échelle et de décalage.

Ici, le test 1) est le suivant : $\sigma_\psi < S_1$ et $\sigma_\theta < S_1$ et $\sigma_\varphi < S_1$, où :

- $\sigma_\psi$, $\sigma_\theta$ et $\sigma_\varphi$ sont des marges d'erreur et, plus précisément, les écart-types les plus récemment établis par l'algorithme de fusion pour, respectivement, les estimations des angles de lacet, de tangage et de roulis, et
- $S_1$ est un seuil prédéterminé.

Typiquement, la valeur du seuil $S_1$ est inférieure à 10° ou 5°. Ici, le seuil $S_1$ est choisi égal à 5°. Si le test 1) est satisfait, c'est que la précision sur les estimations des angles de lacet, de tangage et de roulis sont suffisamment précises.

Le test 2) consiste à déterminer s'il n'existe pas un perturbateur magnétique temporairement situé à proximité du magnétomètre 30. Un tel perturbateur est appelé "perturbateur magnétique temporaire" par la suite. Un perturbateur magnétique modifie le champ magnétique mesuré par le magnétomètre 30 de sorte que celui-ci ne correspond pas exactement au champ géomagnétique. Par exemple, un perturbateur magnétique peut être une pièce métallique ou un aimant permanent. Un perturbateur magnétique temporaire est, par exemple, un perturbateur magnétique qui se déplace ans le repère $R_b$. Si les coefficients d'échelle et de décalage sont mis à jour en présence d'un perturbateur magnétique temporaire, les valeurs mises à jour de ces coefficients permettent d'éliminer en grande partie les erreurs de mesure causées par ce perturbateur. Toutefois, si ce perturbateur disparaît ensuite pendant la période d'inactivité, alors au démarrage de la prochaine période d'activité, l'estimation initiale de l'angle de lacet sera mauvaise. Cela ralentira fortement la convergence de l'algorithme de fusion vers une estimation précise de la position et de l'orientation du véhicule 2. Ici, pour remédier à ce problème, la mise à jour des valeurs courantes 34 des coefficients d'échelle et d'orientation est inhibée si la présence d'un perturbateur magnétique temporaire à proximité du magnétomètre 30 est détectée.

Ici, le test 2) est le suivant $| \, \|B_{raw}\| - \|B_0\| \, | < S_2$, où :

- $\|B_{raw}\|$ est la norme du vecteur $B_{raw}$ actuellement mesuré,
- $\|B_0\|$ est la norme du vecteur de référence, par exemple obtenu à l'issue de l'opération 58,
- $S_2$ est un seuil prédéterminé,
- $|\ \|B_{raw}\| - \|B_0\|\ |$ est la valeur absolue de la différence entre les normes $\|B_{raw}\|$ et $\|B_0\|$.

Typiquement, le seuil $S_2$ est inférieure à 40 $\mu$T ou 20 $\mu$T Ici, le seuil $S_2$ est égal à 20 $\mu$T. Si le test 2) n'est pas satisfait, il est déterminé qu'il existe un perturbateur à proximité du magnétomètre 30.

Le test 2) présente l'avantage d'être indépendant de la précision sur l'estimation de l'orientation du véhicule 2. Par contre, l'écart entre les normes est aussi fonction d'imperfection interne du magnétomètre 30 de sorte que la valeur du seuil $S_2$ ne peut pas être choisie trop petite. Le test 2) est aussi insensible aux perturbations magnétiques qui modifient uniquement la direction du champ magnétique mesuré par le magnétomètre 30 sans en modifier la norme.

Le test 3) est un autre test qui permet de déterminer s'il existe un perturbateur magnétique temporairement situé à proximité du magnétomètre 30. Ce test 3) est plus sensible à la présence d'un perturbateur. Pour cela, il compare l'écart entre les composantes du vecteur $B_{raw}$ et des estimations de ces composantes. Les estimations des composantes du vecteur $B_{raw}$ sont obtenues à partir des composantes du vecteur $B_0$ et à partir de l'estimation actuelle de l'orientation du véhicule 2.

Ici, le test 3) est le suivant : $|Y_{k,x} / \sigma_{Y,x}| < S_3$ et $|Y_{k,y} / \sigma_{Y,y}| < S_3$ et $|Y_{k,z} / \sigma_{Y,z}| < S_3$ où :

- $Y_{k,x}$, $Y_{k,y}$, $Y_{k,z}$ sont les écarts entre les composantes du vecteur $B_{raw}$ et l'estimation de ces composantes,
- $\sigma_{Y,x}$, $\sigma_{Y,y}$ et $\sigma_{Y,z}$ sont des écart-types causés par les incertitudes sur l'estimation des coefficients d'échelle et de décalage et les erreurs de mesure,
- $/$ est le symbole de l'opération de division,
- $|...|$ est le symbole qui désigne l'opération valeur absolue, et
- $S_3$ est un seuil prédéterminé.

Un exemple de calcul des écarts $Y_{k,x}$, $Y_{k,y}$, $Y_{k,z}$ et des écart-types $\sigma_{Y,x}$, $\sigma_{Y,y}$ et $\sigma_{Y,z}$ est décrit en détail en référence à la figure 3. En général, le seuil $S_3$ est inférieur à 4 ou 3. Ici, le seuil $S_3$ est égal à 3. Si le test 3) n'est pas satisfait, il est déterminé qu'il existe un perturbateur à proximité du magnétomètre 30.

Le test 4) consiste à vérifier qu'au moins l'angle de lacet du véhicule 2 a suffisamment été modifié depuis la dernière mise à jour des valeurs courantes 34. En effet, lorsque le véhicule 2 est dans une situation où l'angle de lacet reste constant pendant un intervalle de temps assez long, il est inutile, voire risqué, d'essayer de mettre à jour plusieurs fois les valeurs courantes 34 des coefficients d'échelle et de décalage pendant cet intervalle. Plus précisément, pendant cet intervalle, il n'est pas possible de savoir si une erreur de mesure du magnétomètre 30 doit être corrigée en modifiant la valeur d'un coefficient d'échelle ou la valeur d'un coefficient de décalage. Ainsi, dans cette situation particulière, une perturbation transitoire de la mesure du magnétomètre 30 peut conduire à dégrader la calibration du magnétomètre 30 au lieu de l'améliorer. De plus, dans tous les cas, la mise à jour des valeurs courantes 34 dans cette situation est inutile. Le test 4) permet donc d'éliminer ce risque de dégrader la calibration et d'éviter des mises à jour inutiles des valeurs courantes 34 dans de telles situations.

Ici, le test 4) est le suivant : $\|\ Angle - LastAngle\ \| < S_4$, où :

- « Angle » est un vecteur comportant les valeurs des trois angles $\psi$, $\theta$ et $\varphi$ les plus récemment déterminées pour les angles, respectivement, de lacet, de tangage et de roulis du véhicule 2,
- « LastAngle » est un vecteur comportant les valeurs des trois angles $\psi$, $\theta$ et $\varphi$ déterminées au moment de la dernière mise à jour des valeurs courantes 34,
- $\|...\|$ est la norme de la différence entre les vecteurs « Angle » et « LastAngle », et
- $S_4$ est un seuil prédéterminé.

La valeur du seuil $S_4$ est typiquement inférieure à 5° ou 2°. Ici, la valeur du seuil $S_4$ est inférieure à 1°. La valeur du seuil $S_4$ est également de préférence supérieure à 0,5° ou 1°. Si le test 4) est satisfait, il est déterminé que l'angle de lacet n'a pas suffisamment été modifié depuis la dernière mise à jour des valeurs courantes 34.

Si l'ensemble des tests réalisés lors de l'opération 82 confirme que la situation est propice à une mise à jour des valeurs courantes 34 des coefficients d'échelle et de décalage, alors il est procédé à une étape 84 d'établissement de nouvelles valeurs courantes 34 pour les coefficients d'échelle et de décalage.

Lors de l'étape 84, les nouvelles valeurs courantes 34 sont mises à jour par le module 36 de manière à réduire l'écart entre les composantes des vecteurs $B_C$ et $B_0$ lorsque ces composantes sont exprimées dans un repère commun. A cet effet, le vecteur $B_0$ est, par exemple, celui obtenue lors de l'opération 58. Ici, le repère commun est le repère $R_b$. Plus précisément, à cet effet, le module 36 exécute un algorithme d'estimation qui établit une nouvelle estimation des valeurs des coefficients d'échelle et de décalage à partir :

- de la nouvelle mesure du champ géomagnétique par le magnétomètre 30,
- du vecteur de référence $B_0$,
- de la précédente estimation des valeurs courantes établies pour les coefficients d'échelle et de décalage, et
- de l'estimation actuelle de l'orientation du véhicule 2.

Un mode de réalisation de cet algorithme d'estimation est décrit plus en détail en référence au procédé de la figure 3.

Une fois ces nouvelles estimations des valeurs courantes 34 établies, celles-ci sont enregistrées dans la mémoire 24 et remplacent les précédentes valeurs courantes 34.

Dans ce mode de réalisation, à l'issue de l'étape 84, lors d'une étape 86, la qualité des nouvelles estimations des valeurs courantes 34 est vérifiée. A cet effet, lors de cette étape 86, le module 36 met en œuvre deux tests appelés par la suite, respectivement, test 5) et test 6).

Le test 5) consiste à s'assurer que les nouvelles estimations des valeurs des coefficients d'échelle et de décalage sont dans des plages plausibles prédéterminées de valeurs. Ici, le test 5) est mis en œuvre uniquement pour les nouvelles estimations des coefficients d'échelle. Par exemple, le test 5) consiste ici à vérifier les trois conditions suivantes :

- condition 5.1 : $S_{5min} < 1/a_x < S_{5max}$,
- condition 5.2 : $S_{5min} < 1/a_y < S_{5max}$,
- condition 5.3 : $S_{5min} < 1/a_z < S_{5max}$,
  où :
- $1/a_x$, $1/a_y$ et $1/a_z$ sont les nouvelles estimations des coefficients d'échelle pour les axes de mesure, respectivement, $x_b$, $y_b$ et $z_b$ du magnétomètre 30,
- $S_{5min}$ et $S_{5max}$ sont des seuils prédéterminés.

Le calcul des valeurs des coefficients $a_x$, $a_y$ et $a_z$ sont décrits en détail en référence au procédé de la figure 3.

Dans ce mode de réalisation, la valeur du seuil $S_{5min}$ est généralement inférieure à $1/s$, où s est un nombre supérieur ou égal à 1,5 ou 2 ou 3. La valeur du seuil $S_{5max}$ est quant à elle généralement supérieure ou égale à s. Ici, les seuils $S_{5min}$ et $S_{5max}$ sont, respectivement, égaux à 0,5 et 2.

Dans ce mode de réalisation, lorsque la condition 5.1 n'est pas satisfait par le coefficient $1/a_x$, alors sa valeur est bornée, c'est-à-dire modifiée pour rester à l'intérieur de la plage $[S_{5min} ; S_{5max}]$. Pour cela, si le coefficient $1/a_x$ est inférieur à $S_{5min}$, la valeur du coefficient $a_x$ est automatiquement modifiée de telle sorte que $1/a_x$ soit égale à $S_{5min}$. A l'inverse, si le coefficient $1/a_x$ est supérieur à $S_{5max}$, la valeur du coefficient $a_x$ est automatiquement modifiée de telle sorte que $1/a_x$ soit égal à $S_{5max}$. Le même mécanisme de bornage est mis en œuvre pour les coefficients $1/a_y$ et $1/a_z$.

Le test 6) consiste à vérifier que la marge d'erreur sur l'estimation d'un ou plusieurs des coefficients d'échelle et de décalage est suffisamment faible pour qu'ils soient utilisables pour corriger les mesures du magnétomètre 30.

Ici, le test 6) consiste à vérifier les six conditions suivantes :

- condition 6.1 : $P_k(1,1) < S_{6s}$,
- condition 6.2 : $P_k(2,2) < S_{6s}$,
- condition 6.3 : $P_k(4,4) < S_{6o}$,
- condition 6.4 : $P_k(5,5) < S_{6o}$,
- condition 6.5 : $P_k(3,3) < S_{6s}$,
- condition 6.6 : $P_k(6,6) < S_{6o}$,
  où :
- les coefficients $P_k(1,1)$, $P_k(2,2)$ et $P_k(3,3)$ sont des coefficients diagonaux d'une matrice de covariance Pk qui sont fonctions des marges d'erreur sur les estimations des coefficients d'échelle pour, respectivement, les axes $x_b$, $y_b$ et $z_b$,
- les coefficients $P_k(4,4)$, $P_k(5,5)$ et $P_k(6,6)$ sont des coefficients diagonaux de la matrice de covariance $P_k$ qui sont fonctions des marges d'erreur sur les nouvelles estimations des coefficients de décalage pour, respectivement, les axes $x_b$, $y_b$ et $z_b$, et
- $S_{6s}$ et $S_{6o}$ sont des seuils prédéterminés.

La valeur du seuil $S_{6s}$ est généralement inférieure ou égale à 1 ou 0,5 ou 0,33. Ici, la valeur du seuil $S_{6s}$ est égale à 0,33. La valeur du seuil $S_{6o}$ est généralement inférieure à 10 $\mu$T ou 5 $\mu$T ou 3 $\mu$T. Par exemple, ici, les seuils $S_{6s}$ et $S_{6o}$ sont égaux à 0,33 et 3 $\mu$T.

Dans le cas d'un véhicule qui se déplace essentiellement horizontalement, les variations de la mesure le long de l'axe $z_b$ sont faibles. Dès lors la marge d'erreur sur les coefficients d'échelle et de décalage pour corriger la composante brute du magnétomètre le long de cet axe $z_b$ peut diminuer beaucoup plus lentement que la marge d'erreur sur les coefficients d'échelle et de décalage associés à des axes de mesure horizontaux. De plus, pour ce type de véhicule, la mesure du champ magnétique le long de l'axe $z_b$ n'est pas très importante et influence peu l'estimation initiale de l'angle de lacet. Par conséquent, une imprécision importante sur les coefficients d'échelle et de décalage associés à l'axe $z_b$ n'est pas nécessairement gênante. La suite de la description est faite dans ce cas particulier. Par conséquent, dans ce mode de réalisation, si l'une des conditions 6.1, 6.2, 6.4 ou 6.5 n'est pas satisfaite, alors la valeur de l'indicateur $I_{CF}$ est prise égale à 0. Ainsi, si cet indicateur $I_{CF}$ reste égal à 0 jusqu'à la fin de la période d'activité en cours, lors de la prochaine période d'activité, l'angle de lacet sera initialisé en utilisant les valeurs 32 par défaut.

Si les quatre conditions 6.1, 6.2, 6.4 et 6.5 sont satisfaites et que au moins l'une des conditions 6.3 et 6.6 ne l'est pas, alors la valeur de l'indicateur $I_{CF}$ est prise égale à un.

Si les six conditions 6.1 à 6.6 sont satisfaites, alors la valeur de l'indicateur $I_{CF}$ est prise égale à deux.

A l'issue de l'étape 86, le procédé retourne à l'étape 81. Ainsi, la calibration du magnétomètre 30 est exécutée en permanence jusqu'à la fin de la période d'activité en cours. Si l'indicateur $I_{CF}$ est supérieur ou égal à 0 jusqu'à la fin de la période d'activité en cours, au début de la prochaine période d'activité, l'estimation initiale de l'angle de lacet sera obtenue en utilisant les dernières valeurs courantes 34 enregistrées dans la mémoire 24 lors de la précédente période d'activité. Le procédé décrit ici permet donc de disposer dans la majorité des cas, de valeurs courantes 34 qui permettent une meilleure correction du vecteur $B_{raw}$ et donc une estimation initiale de l'angle de lacet plus précise. Cela permet donc d'accélérer grandement la convergence de l'algorithme de fusion vers une estimation précise de la position et de l'orientation du véhicule 2.

La figure 3 représente plus en détail un procédé d'établissement d'une nouvelle estimation des valeurs courantes des coefficients d'échelle et de décalage. Ce procédé est mis en œuvre lors de l'étape 84. Ici, ce procédé est décrit dans le cas particulier où l'algorithme d'estimation utilisé est un filtre de Kalman linéaire. Par la suite, la terminologie et les notations utilisées correspondent à celles utilisées classiquement pour des filtres de Kalman.

Les notations et les relations suivantes utilisées dans ce filtre de Kalman sont maintenant définies.

$B_0^n$ est le vecteur de référence obtenu lors de l'exécution de l'opération 58 et dont les composantes sont exprimées dans le repère $R_T$.

$B_0^b$ est le vecteur de référence dont les composantes sont exprimées dans le repère $R_b$.

$C_n^b$ est une matrice de rotation qui permet de convertir les composantes d'un vecteur exprimées dans le repère $R_T$ en composantes du même vecteur mais exprimées dans le repère $R_b$. Cette matrice $C_n^b$ est une matrice carrée de trois lignes et de trois colonnes. Les coefficients de la matrice $C_n^b$ sont établis à partir des estimations des angles $\psi$, $\theta$ et $\varphi$ fournies par l'algorithme de fusion. On a donc la relation suivante :

$$\underline{\text{Relation 1)}} : B_0^b = C_n^b . B_0^n .$$

Dans cette relation 1) comme dans les relations suivantes, le symbole "." désigne l'opération de multiplication.

Le vecteur $B_{raw}$ est modélisé par la relation suivante :

$$\underline{\text{Relation 2)}} : B_{raw} = A . B_0^b + Off + \eta,$$

où :

- Off est un vecteur de trois composantes $Off_x$, $Off_y$, $Off_z$, les composantes $Off_x$, $Off_y$, $Off_z$ étant associés, respectivement, aux axes $x_b$, $y_b$ et $z_b$,
- A est une matrice diagonale carrée de trois lignes et de trois colonnes dont les trois coefficients de sa diagonale sont $a_x$, $a_y$ et $a_z$, les coefficients $a_x$, $a_y$ et $a_z$ étant associés, respectivement, aux axes $x_b$, $y_b$ et $z_b$, et
- $\eta$ désigne le bruit de mesure du magnétomètre 30.

Le vecteur $B_C$ est obtenu à l'aide de la relation suivante :

$$\underline{\text{Relation 3)}} : B_C = S . (B_{raw} - Off) ,$$

où S est l'inverse de la matrice A définie dans la relation 2).

C'est donc cette relation 3) qui est utilisée lors de l'opération 54 pour corriger le vecteur $B_{raw}$. Les coefficients d'échelle associés aux axes $x_b$, $y_b$ et $z_b$ sont donc égaux, respectivement, à $1/a_x$, $1/a_y$ et $1/a_z$. Les coefficients de décalage associés aux axes $x_b$, $y_b$ et $z_b$ sont égaux, respectivement, à $-Off_x/a_x$, $-Off_y/a_y$ et $-Off_z/a_z$.

Le vecteur d'état $X_k$ est défini par la relation suivante :

$$\underline{\text{Relation 4)}} : X_k = [a_x, a_y, a_z, Off_x, Off_y, Off_z]^T,$$

où :

- les composantes $a_x$, $a_y$, $a_z$, $Off_x$, $Off_y$, $Off_z$ sont les mêmes coefficients que ceux définis dans la relation 2),
- le symbole « $T$ » désigne l'opération transposée,
- l'indice k est un numéro d'ordre.

L'équation de propagation ou de prédiction de l'état du filtre de Kalman est définie par la relation suivante :

$$\underline{\text{Relation 5)}} : X_{k+1|k} = X_{k|k} + v,$$

où :

- $X_{k|k}$ est l'estimation du vecteur d'état à l'instant k obtenue en prenant en compte toutes les mesures jusqu'à l'instant k,
- $X_{k+1|k}$ est l'estimation du vecteur d'état à l'instant k+1 obtenue en prenant en compte seulement les mesures jusqu'à l'instant k,
- $v$ est le bruit du processus.

La relation 5) s'explique par le fait que les coefficients d'échelle et de décalage sont supposés, en première approximation, comme étant constants au cours du temps.

L'équation de propagation ou de prédiction de la matrice de covariance de l'erreur est définie par la relation suivante :

$$\underline{\text{Relation 6)}} : P_{k+1|k} = P_{k|k} + Q_k, \text{ où :}$$

- $P_{k|k}$ est l'estimation de la matrice de covariance de l'erreur à l'instant k obtenue en prenant en compte toutes les mesures jusqu'à l'instant k,
- $P_{k+1|k}$ est l'estimation de la matrice de covariance à l'instant k+1 obtenue en prenant seulement en compte les mesures jusqu'à l'instant k,
- $Q_k$ est la matrice de covariance du bruit de processus v.

La matrice $Q_k$ est définie par la relation suivante :

$$\underline{\text{Relation 7)}} :$$

$$Q_k = \begin{bmatrix} \sigma_{scale}^2 & & & & & \\ & \sigma_{scale}^2 & & & & \\ & & \sigma_{scale}^2 & & & \\ & & & \sigma_{Off}^2 & & \\ & & & & \sigma_{Off}^2 & \\ & & & & & \sigma_{Off}^2 \end{bmatrix}$$

où :

- $\sigma_{scale}^2$ est la variance du bruit de processus v dans l'estimation de chaque coefficient d'échelle, et
- $\sigma_{Off}^2$ est la variance du bruit de processus v dans l'estimation de chaque coefficient de décalage.

A titre d'illustration, les valeurs typiques des coefficients $\sigma_{scale}^2$ et $\sigma_{Off}^2$ sont, respectivement, $10^{-8}$ et $10^{-6}$.

En utilisant les notations précédemment introduites, le modèle du vecteur $B_{raw}$ est défini par la relation suivante :

<u>Relation 8)</u> : $B_{raw} = H_k \cdot X_k + \eta$,

où :

- $\eta$ est le bruit sur la mesure, et
- $H_k$ est la matrice définie par la relation suivante :

<u>Relation 9)</u> :

$$H_k = \begin{bmatrix} B_{0,x}^b & 0 & 0 & 1 & & 0 \\ 0 & B_{0,y}^b & 0 & & 1 & 0 \\ 0 & 0 & B_{0,z}^b & 0 & 0 & 1 \end{bmatrix}$$

où $B_{0,x}^b$, $B_{0,y}^b$, $B_{0,z}^b$ sont les trois composantes du vecteur $B_0^b$ exprimées dans le repère $R_b$ et obtenu à l'aide de la relation 1). On notera que les composants $B_{0,x}^b$, $B_{0,y}^b$, $B_{0,z}^b$ sont fonctions des estimations des angles de lacet, de tangage et de roulis établis par l'algorithme de fusion. Ainsi, la matrice $H_k$ est mise à jour à chaque nouvelle estimation de ces angles de lacet, de tangage et de roulis établie par l'algorithme de fusion.

L'innovation $Y_k$, c'est-à-dire l'écart entre le vecteur $B_{raw}$ et l'estimation de ce vecteur obtenue à l'aide du vecteur $B_0$, est donnée par la relation suivante :

<u>Relation 10)</u> : $Y_k = B_{raw} - H_k \cdot X_{k|k-1}$.

La covariance $S_k$ de l'innovation est donnée par la relation suivante :

<u>Relation 11)</u> : $S_k = H_k \cdot P_{k|k-1} \cdot H_k^\top + R_k$,

où $R_k$ est la matrice de covariance du bruit de mesure.

La matrice $S_k$ est une matrice diagonale de trois lignes et de trois colonnes. Les coefficients de sa diagonale sont notés $\sigma_{Y,x}^2$, $\sigma_{Y,y}^2$ et $\sigma_{Y,z}^2$ et correspondent au carré des coefficients utilisés dans le test 3).

La matrice $R_k$ est définie par la relation suivante :

<u>Relation 12)</u> :

$$R_k = \begin{bmatrix} \sigma_{MagNoise}^2 & 0 & 0 \\ 0 & \sigma_{MagNoise}^2 & 0 \\ 0 & 0 & \sigma_{MagNoise}^2 \end{bmatrix}$$

où $\sigma_{MagNoise}^2$ est la variance du bruit de mesure du magnétomètre 30 et des perturbations du champ magnétique mesuré. Typiquement, la valeur du coefficient $\sigma_{MagNoise}^2$ est choisie entre 1 $\mu$T et 10 $\mu$T. Par exemple, ici, ce coefficient est égal à 10 $\mu$T.

Le gain de Kalman est défini par la relation suivante :

<u>Relation 13)</u> : $K_k = P_{k|k-1} \cdot H_k^\top \cdot S_k^{-1}$.

L'équation de mise à jour de l'estimation du vecteur d'état $X_k$ est définie par la relation suivante :

Relation 14) : $X_{k|k} = X_{k|k-1} + K_k.Y_k.$

L'équation de mise à jour de l'estimation de la matrice de covariance de l'erreur est définie par la relation suivante :

Relation 15) : $P_{k|k} = (I - K_k.H_k).P_{k|k-1},$

où I est la matrice identité.

Le procédé d'estimation des coefficients d'échelle et de décalage débute par une étape 100 d'initialisation de l'algorithme d'estimation. Lors de l'étape 100, si la valeur de l'indicateur $I_{CF}$ est égale à 0, le vecteur d'état initial $X_0$ est défini par la relation suivante :

Relation 16) : $X_0 = [a_{x0}\ a_{y0}\ a_{z0}\ Off_{x0}\ Off_{y0}\ Off_{z0}]^T,$

où :

- les coefficients $a_{x0}$, $a_{y0}$, $a_{z0}$ sont égaux, respectivement, à $1/e_{x0}$, $1/e_{y0}$ et $1/e_{z0}$, où $e_{x0}$, $e_{y0}$ et $e_{z0}$ sont les valeurs 32 par défaut des coefficients d'échelle associés, respectivement, aux axes $x_b$, $y_b$ et $z_b$,
- les coefficients $Off_{x0}$, $Off_{y0}$, $Off_{z0}$ sont égaux, respectivement, à $-a_{x0}.d_x$, $-a_{y0}.d_y$ et
- $a_{z0}.d_z$, où $d_x$, $d_y$ et $d_z$ sont les valeurs 32 par défaut des coefficients de décalage associés, respectivement, aux axes $x_b$, $y_b$ et $z_b$.

La matrice initiale $P_0$ de covariance de l'erreur est définie par la relation suivante :

Relation 17) :

$$P_0^{Default} = \begin{bmatrix} \sigma^2_{scale0} & & & & & \\ & \sigma^2_{scale0} & & & & \\ & & \sigma^2_{scale0} & & & \\ & & & \sigma^2_{Off0} & & \\ & & & & \sigma^2_{Off0} & \\ & & & & & \sigma^2_{Off0} \end{bmatrix}$$

où :

- $P_0^{Defaut}$ est égale à la matrice $P_0$, et
- les coefficients $\sigma_{scale0}^2$ et $\sigma_{Off0}^2$ définissent l'incertitude par défaut sur l'estimation, respectivement, des coefficients $a_x$, $a_y$ et $a_z$ et des coefficients $Off_x$, $Off_y$ et $Off_z$.

A titre d'illustration, les coefficients $\sigma_{scale0}$ et $\sigma_{Off0}$ sont, respectivement, égaux à 0,1 et 100 µT.

Si lors de l'étape 100, la valeur de l'indicateur $I_{CF}$ est supérieure ou égale à un, le vecteur $X_0$ et la matrice $P_0$ sont pris égaux, respectivement, au dernier vecteur $X_{k|k}$ et à la dernière matrice $P_{k|k}$ établis lors de la précédente période d'activité.

Ensuite, pour chaque nouvelle mesure du magnétomètre 30 acquise par le calculateur 20, les opérations suivantes sont exécutées.

Lors d'une opération 102, la matrice $P_{k+1|k}$ de covariance de l'erreur est estimée en utilisant la relation 6).

Lors d'une opération 104, les coefficients de la matrice $H_k$ sont mis à jour en fonction de la dernière estimation de l'orientation du véhicule 2. Plus précisément, c'est la matrice de rotation $C_n^b$ qui est mise à jour en fonction de cette dernière estimation de l'orientation. Ensuite, les composantes $B_{0,x}^b$, $B_{0,y}^b$ et $B_{0,z}^b$ sont calculées en multipliant le vecteur $B_0^n$ par la matrice $C_n^b$ mise à jour. Enfin, toujours lors de l'opération 104, l'innovation $Y_k$ et la matrice $S_k$ de covariance de l'innovation sont calculées en utilisant, respectivement, les relations 10) et 11).

De préférence, lors d'une opération 106, le test 3) est exécuté immédiatement après le calcul des nouveaux coefficients $\sigma_{Y,x}^2$, $\sigma_{Y,y}^2$ et $\sigma_{Y,z}^2$ de la matrice $S_k$. Cela permet d'éviter d'exécuter inutilement l'opération suivante.

Seulement si le test 3) est satisfait, alors, lors d'une opération 108, le gain $K_k$, le vecteur $X_{k|k}$ et la matrice $P_{k|k}$ sont calculés en utilisant, respectivement, les relations 13), 14) et 15). A partir des composantes du vecteur $X_{k|k}$, les nouvelles valeurs des coefficients d'échelle $e_x$, $e_y$ et $e_z$ et les nouvelles valeurs des coefficients de décalages $d_x$, $d_y$ et $d_z$ sont mis à jour en utilisant les relations introduites en référence à la relation 3).

Chapitre II : Variantes

Variantes du champ $B_0$ :

La position initiale pour obtenir le vecteur $B_0$ au démarrage d'une nouvelle période d'activité peut être fournie par un autre système que l'unité 10 de géolocalisation par satellite. Par exemple, si le système 6 est habituellement immobile pendant les périodes d'inactivité, la position au démarrage de la nouvelle période d'activité est prise égale à la dernière position estimée lors de la précédente période d'activité.

Dans un autre mode de réalisation et dans l'hypothèse où le système de localisation reste immobile entre deux périodes d'activité successives, le dernier vecteur $B_0$ utilisé lors de la précédente période d'utilisation est mémorisé. Ensuite, au début de la période d'activité suivante, c'est ce vecteur $B_0$ mémorisé lors de la précédente période d'activité qui est utilisé. Cela permet de ne pas avoir à mettre à jour le vecteur $B_0$ à partir de la position mesurée par l'unité 10 tant que les déplacements du véhicule 2 au cours de la présente période d'activité restent faibles.

Dans un mode de réalisation simplifié, quelle que soit la position du véhicule 2, la norme du vecteur $B_0$ est considérée comme constante. Dans ce cas, le modèle 38 peut être simplifié en ne mémorisant que les données nécessaires pour déterminer la direction du vecteur $B_0$ en fonction de la position et sans qu'il soit nécessaire de déterminer la norme de ce vecteur $B_0$. Les opérations 56 et 58 peuvent donc être omises.

Dans le cas particulier où le véhicule comporte une masse métallique ou magnétique systématiquement immobile par rapport au système 6 et qui modifie la direction du champ géomagnétique qui traverse le magnétomètre 30, cette perturbation du champ géomagnétique peut être directement intégrée dans le modèle 38.

Variantes de l'algorithme d'estimation des coefficients d'échelle et de décalage :

D'autres choix sont possibles pour le vecteur d'état initial $X_0$ lorsque l'indicateur $I_{CF}$ est égal à zéro. Par exemple, en variante, le vecteur $X_0$ est choisi égal à [1 1 1 0 0 0]T.

Dans certains cas, la valeur du coefficient d'échelle d'un axe de mesure du magnétomètre 30 dépend aussi de façon non négligeable des composantes du champ magnétique mesurées sur d'autres axes de mesure. Dans ce cas, la matrice A n'est pas une matrice diagonale et les coefficients de la matrice A qui ne sont pas situés sur sa diagonale doivent également être estimés. Pour cela, le vecteur d'état $X_k$ est agrandi pour comporter les neufs coefficients de la matrice A et non pas seulement les trois coefficients $a_x$, $a_y$ et $a_z$ de la diagonale. Les différentes équations du filtre de Kalman linéaire doivent être adaptées en conséquence.

En variante, le repère commun dans lequel le vecteur $B_{raw}$ est comparé au vecteur $B_0$ est un autre repère que le repère $R_b$. Par exemple, le repère commun est le repère $R_T$. Dans ce cas, l'orientation estimée du véhicule est utilisée pour construire une matrice de rotation qui permet de convertir les composantes du vecteur $B_{raw}$, exprimées dans le repère $R_b$, en composantes exprimées dans le repère terrestre $R_T$. L'algorithme d'estimation des coefficients d'échelle et de décalage doit alors être adapté pour tenir compte du fait que le repère commun est le repère $R_T$ et non pas le repère $R_B$. Éventuellement, le repère commun peut aussi être un troisième repère différent des repères $R_b$ et $R_T$ à partir du moment où il est possible de construire, à partir de l'orientation déterminée du véhicule 2, les matrices de rotation qui permettent d'exprimer les vecteurs $B_{raw}$ et $B_0$ dans ce repère commun.

Ici, les coefficients d'échelle et de décalage sont établis de manière à minimiser l'écart entre le vecteur $B_C$ et le vecteur $B_0^b$. Pour cela, l'algorithme d'estimation a été décrit dans le cas particulier où il s'agit d'un filtre de Kalman linéaire. Toutefois, tout autre algorithme d'estimation permettant de résoudre le même problème peut être utilisé. A titre d'exemple d'autres algorithmes d'estimation utilisables, on peut citer les algorithmes suivants : un filtre de Kalman étendu, un filtre particulaire, l'algorithme des moindres carrés récursifs connu sous l'acronyme RLS (« recursive least squares »), un estimateur de maximum de vraisemblance ou tout autre estimateur déterministe.

Si les déplacements du véhicule 2 depuis la dernière exécution de l'opération 58 sont suffisamment petits pour pouvoir considérer qu'ils ne provoquent pas de changement significatif du vecteur $B_0$, alors tant que cette condition est vérifiée, le vecteur $B_0$ n'est pas recalculé pendant l'exécution de la phase 80 de calibration. A l'inverse, si les déplacements mesurés du véhicule 2 sont suffisamment importants pour correspondre à un changement significatif du vecteur $B_0$, alors, au cours de la phase 80, l'opération 58 est de nouveau exécuté en prenant cette fois-ci en compte la position actuellement estimée par le module 26. Ainsi, le vecteur de référence utilisé lors de la phase 80 n'est pas nécessairement le même que celui utilisé lors de la phase 48.

Variante des différents tests décrits :

D'autres modes de réalisation du test 1) sont possibles. Par exemple, lorsqu'un véhicule se déplace systématiquement horizontalement, seule la précision sur la mesure de l'angle de lacet est testée et dès que celle-ci est suffisante, la calibration du magnétomètre 30 est mise à jour sans prendre en compte la précision sur la mesure des angles de roulis et de tangage. Ainsi, en variante, le test 1) est remplacé par un test où seul l'écart-type $\sigma_\psi$ est comparé au seuil $S_1$.

Dans une autre variante, les écart-types $\sigma_\psi$, $\sigma_\theta$ et $\sigma_\varphi$ sont chacun comparés à des seuils prédéterminés différents.

Le test 1) peut être modifié pour utiliser, non pas les écart-types $\sigma_\psi$, $\sigma_\theta$ et $\sigma_\varphi$, mais les variances sur les estimations des angles de lacet, de tangage et de roulis.

En variante, une valeur strictement supérieure à zéro est affectée à l'indicateur $I_{CF}$ uniquement si toutes les conditions 6.1 à 6.6 sont vérifiées. Cette variante est notamment utile pour des véhicules susceptibles de présenter une forte inclinaison par rapport à la verticale dès le démarrage du système 6. En effet, dans ce cas, l'angle de lacet dépend également fortement de la précision de la mesure du magnétomètre le long de l'axe de mesure $z_b$. Par exemple, cette variante est utile lorsque le véhicule est un missile sur une rampe de lancement.

L'étape 82 peut comporter plus ou moins de tests. Par exemple, dans un mode de réalisation très simplifié, seul le test 1) est mis en œuvre lors de l'étape 82. Dans un autre mode de réalisation, des tests supplémentaires sont mis en œuvre lors de l'étape 82. Par exemple, un test sur la précision de l'estimation de la position du véhicule 2 est mis en œuvre afin de déclencher la calibration du magnétomètre 30 uniquement si la position est connue avec une précision suffisante. Il est aussi possible d'ajouter un test qui vérifie que la norme du vecteur $B_{raw}$ est supérieure à un seuil prédéterminé de manière à inhiber la mise à jour des valeurs courantes 34 en présence d'un champ géomagnétique trop faible. Une telle situation peut se rencontrer, par exemple, en présence d'un perturbateur qui génère un champ d'une intensité sensiblement égale aux champ géomagnétique mais dans une direction opposée.

D'autres modes de réalisation du test 5) sont également possibles. Par exemple, le test 5) est modifié pour vérifier en plus que les nouvelles estimations des valeurs des coefficients de décalage sont situées à l'intérieur de plages possibles prédéterminées de valeurs. Dans un autre mode de réalisation simplifié, le test 5) est omis. Dans ce cas-là, les valeurs des coefficients d'échelle et de décalage ne sont pas bornées. Dans un autre mode de réalisation, lorsque le test 5) n'est pas vérifié, au lieu de borner les nouvelles estimations des valeurs du coefficient d'échelle, celles-ci ne sont pas modifiées mais la valeur de l'indicateur $I_{CF}$ est prise égale à zéro.

D'autres modes de réalisation du test 6) sont possibles. Par exemple, si une précision suffisante sur les coefficients $a_x$ et $a_y$ garantie déjà à elle seule une estimation suffisamment précise de l'angle de lacet, alors le test 6) peut être simplifié. Par exemple, le test 6) ne comporte plus que les conditions 6.1 et 6.2.

En variante, l'étape 86 de vérification de la qualité de la calibration est omise. Dans ce cas, la valeur de l'indicateur $I_{CF}$ est systématiquement prise égale à deux après l'exécution de l'étape 84.

Autres variantes :

Le système 6 décrit ici peut être utilisé dans d'autres véhicules comme un sous-marin. De façon générale, on désigne ici par "véhicule" tout objet susceptible de se déplacer et équipé d'un système 6 fixé sur cet objet pour déterminer sa position et son orientation. Par exemple, le véhicule peut être un missile, une fusée, un smartphone, un ordinateur portable ou similaire.

Le magnétomètre 30 peut être intégré dans l'unité 12 de navigation inertielle. Il peut aussi se présenter comme un composant indépendant de l'unité 12 et fixé mécaniquement à l'unité 12 et à l'unité 10 de géolocalisation par satellite.

Le système 6 peut comporter des capteurs supplémentaires pour améliorer encore plus la précision avec laquelle la position et l'orientation du véhicule sont déterminées. Par exemple, le système 6 peut comporter :

- un capteur de pression afin d'améliorer la détermination de l'altitude du véhicule, et/ou
- un odomètre, tel qu'un podomètre, qui mesure la distance parcourue par le véhicule 2 entre deux instants successifs.

D'autres modes de réalisation du magnétomètre 30 sont possibles. Par exemple, dans le cas d'un véhicule 2 se déplaçant uniquement horizontalement, le magnétomètre 30 peut être remplacé par un magnétomètre biaxe, c'est-à-dire un magnétomètre comportant seulement deux axes horizontaux de mesure. Dans d'autres modes de réalisation, le magnétomètre 30 est remplacé par un magnétomètre comportant plus de trois axes de mesure non colinéaires. Dans ce dernier cas, une partie des mesures sont redondantes, ce qui peut être exploité pour augmenter la précision de la mesure.

Lors de l'étape 56, l'estimation initiale de la position du véhicule peut être réalisée différemment. Par exemple, cette estimation initiale est réalisée en prenant en compte, en plus ou à la place des mesures de l'unité 10, les mesures d'autres capteurs embarqués dans le véhicule ou les mesures de l'unité 12 et/ou du magnétomètre 30.

Lors de l'étape 60, la construction de l'estimation initiale de l'angle de lacet à partir des vecteurs $B_c$ et $B_0$ permet d'obtenir une estimation initiale de l'angle de lacet plus précise que si seul le vecteur $B_c$ était utilisé. Toutefois, en variante, il est aussi possible d'utiliser seulement le vecteur $B_c$ pour construire l'estimation initiale de l'angle de lacet. Par exemple, l'estimation initiale de l'angle de lacet est construite à l'aide de la relation suivante : $\psi_{ini} = \text{atan2}(B_{cx}, B_{cy})$, où :

- $\psi_{ini}$ est l'estimation initiale de l'angle de lacet, et
- $B_{cx}$ et $B_{cy}$ sont les valeurs du champ magnétique $B_c$ mesurées selon les axes, respectivement, $x_b$ et $y_b$ du repère $R_b$,
- "atan2" est la variante connue de la fonction arc-tangente telle que définie, par exemple, dans Wikipedia.

Cette relation est applicable dans les conditions suivantes :

- les axes de mesure du magnétomètre 30 sont parallèles, respectivement, aux axes $x_b$, $y_b$ et $z_b$ du repère $R_b$ embarqué dans le véhicule,
- l'axe $x_b$ est parallèle à la direction dans laquelle se déplace le véhicule lors d'un déplacement en marche avant en ligne droite,
- l'axe yb du magnétomètre pointe vers la gauche du véhicule lors d'un déplacement en marche avant,
- l'axe $z_b$ est vertical est pointe vers le haut.

L'estimation initiale de l'angle de lacet à l'aide de cette relation est assez précise lorsque le véhicule est situé sur un plan horizontal. Dans le cas où le véhicule n'est pas situé sur un plan horizontal, des techniques connues utilisant les mesures de l'accéléromètre 14 permettent d'obtenir la projection des mesures du magnétomètre 30 dans le plan horizontal et ensuite d'utiliser la relation ci-dessus. De telles techniques sont, par exemple, décrites dans le livre de Monsieur de Groves précédemment cité.

De nombreux modes de réalisation différents de l'algorithme de fusion existent. Par exemple, dans un mode de réalisation particulier, les nouvelles mesures du magnétomètre 30 sont aussi prises en compte pour établir chaque nouvelle estimation de la position et de l'orientation du véhicule 2. Si le système 6 comporte d'autres capteurs comme un capteur de pression ou un odomètre, alors l'algorithme de fusion est également modifié pour prendre en plus en compte les mesures de ces autres capteurs.

En variante, les données pré-enregistrées dans la mémoire 24 entre deux périodes d'activités successives sont seulement les valeurs des coefficients $a_x$, $a_y$, $a_z$, $\text{Off}_x$, $\text{Off}_y$ et $\text{Off}_z$. Dans ce cas, lors de l'opération 54, les valeurs courantes des coefficients d'échelle et de décalage sont d'abord calculées à partir des coefficients $a_x$, $a_y$, $a_z$, $\text{Off}_x$, $\text{Off}_y$ et $\text{Off}_z$ pré-enregistrés dans la mémoire 24.

La caractéristique selon laquelle la mise à jour des coefficients d'échelle et de décalage du magnétomètre 30 est réalisée uniquement si aucun perturbateur magnétique n'est détecté à proximité du magnétomètre peut être mise en œuvre indépendamment du test 1). Par exemple, dans un autre mode de réalisation, lors de l'étape 82, le test 2) ou 3) est mis en œuvre et le test 1) est omis.

Chapitre III : Avantages des modes de réalisation décrits

Le fait de déclencher la mise à jour des valeurs courantes 34 des coefficients d'échelle et de décalage uniquement lorsque la marge d'erreur sur l'estimation de l'orientation du véhicule 2 est inférieure au seuil $S_1$, permet d'éviter que la calibration du magnétomètre 30 soit dégradée à cause d'erreurs trop importantes sur cette estimation de l'orientation du véhicule 2. La fiabilité de la calibration du magnétomètre 30 est donc améliorée. Il résulte de cette amélioration que l'estimation initiale de l'angle de lacet au début d'une période d'activité suivante est meilleure, ce qui accélère par la suite la convergence de l'algorithme de fusion vers des estimations plus précises de la position et de l'orientation du véhicule 2. De plus, dans le mode de réalisation décrit, la mise à jour des coefficients d'échelle et de décalage est simple à mettre en œuvre. En particulier, elle peut être mise en œuvre lorsque le véhicule 2 se déplace et ne nécessite pas d'imposer que le véhicule 2 se déplace ou réalise des déplacements prédéterminés à l'avance.

Le fait d'autoriser la mise à jour des coefficients d'échelle et de décalage uniquement lorsque le test 3) est vérifié, permet d'éviter de réaliser une telle mise à jour en présence d'un perturbateur magnétique. Cela contribue à augmenter la fiabilité de la calibration du magnétomètre dès le démarrage d'une période d'activité suivante.

Le fait de tenir compte de l'écart-type dans le test 3) permet d'adapter automatiquement ce test 3) pour que le seuil $S_3$ ne soit pas dépassé en présence seulement d'un bruit habituel sur la mesure du magnétomètre 30. Cela contribue à améliorer la fiabilité de la détection d'un perturbateur à proximité du magnétomètre 30 et donc la fiabilité de la calibration du magnétomètre.

Le test 4) permet d'éviter l'exécution inutile de l'opération 84. De plus, cela réduit le risque que les coefficients d'échelle et de décalage, déterminés dans une situation où l'angle de lacet ne varie pas, puissent diverger et dégrader la calibration du magnétomètre 30.

Le fait de calculer le vecteur $B_0$ en fonction de la position estimée du véhicule permet de prendre en compte le fait que la norme du champ géomagnétique terrestre n'est pas parfaitement uniforme en tout point de la terre. Cela améliorer la précision de la calibration du magnétomètre 30 et donc la rapidité avec laquelle l'algorithme de fusion converge vers une estimation plus précise de la position et de l'orientation du véhicule 2.

Le fait de calculer une marge d'erreur sur l'estimation d'au moins un des coefficients d'échelle et de décalage et d'inhiber l'utilisation de cette nouvelle estimation des coefficients d'échelle et de décalage tant que cette marge d'erreur est trop importante, permet d'éviter d'utiliser des coefficients d'échelle et de décalage trop imprécis pour garantir une estimation fiable de l'angle de lacet.

**Revendications**

1. Procédé de détermination de la position et de l'orientation d'un véhicule, ce procédé comportant :

- la fourniture d'un système de localisation fixé sur ce véhicule, ce système de localisation comportant :

   • une unité de géolocalisation par satellite,
   • une unité de navigation inertielle contenant un accéléromètre et un gyromètre,
   et
   • un magnétomètre comportant au moins deux axes de mesure,

- la mesure (52), par le magnétomètre, d'un premier vecteur de mesures brutes contenant une composante brute pour chacun des axes de mesure, chaque composante codant l'amplitude et la direction de la projection orthogonale du champ magnétique qui traverse ce magnétomètre sur un axe respectif de mesure, ces axes de mesure étant fixes dans un repère mobile tri-axe fixé sur le véhicule, puis
- la correction (54) de chacune des composantes brutes du premier vecteur en la multipliant par un coefficient d'échelle et en y ajoutant un coefficient de décalage pour obtenir une composante corrigée, ces coefficients d'échelle et de décalage étant obtenus à partir de données pré-enregistrées dans une mémoire du système de localisation,
puis
- une estimation initiale (60) de l'angle de lacet du véhicule à partir des composantes corrigées du premier vecteur, puis
- l'initialisation (72), à l'aide de l'estimation initiale de l'angle de lacet, d'un algorithme de fusion apte à établir, à partir de précédentes estimations de la position et de l'orientation du véhicule et en utilisant à la fois les mesures de l'unité de géolocalisation et les mesures de l'unité de navigation inertielle réalisées depuis ces précédentes estimations :

   • de nouvelles estimations de la position et de l'orientation du véhicule, et
   • une marge d'erreur sur cette nouvelle estimation de l'orientation du véhicule, puis

- l'exécution répétée (74) de cet algorithme de fusion pour mettre à jour en continu l'estimation de la position et de l'orientation du véhicule,
**caractérisé en ce que**, après le début de l'exécution répétée de l'algorithme de fusion et en parallèle de l'exécution répétée de l'algorithme de fusion, le procédé comporte une phase (80) de calibration comportant les opérations suivantes :

   1) la mesure (81), par le magnétomètre, d'un deuxième vecteur de mesures brutes,
   2) l'obtention (84) d'un vecteur de référence comportant une composante pour chaque axe de mesure, chacune de ces composantes codant l'amplitude et la direction de la projection orthogonale du champ géomagnétique qui traverse le magnétomètre sur un axe respectif d'un repère terrestre tri-axe fixé sans aucun degré de liberté à la terre, les composantes du vecteur de référence étant obtenues à partir d'un modèle pré-enregistré du champ géomagnétique et non pas mesurées par le magnétomètre, puis
3) uniquement lorsque la marge d'erreur sur l'estimation de l'orientation du véhicule tombe en dessous d'un premier seuil prédéterminé, la mise à jour (84) des données pré-enregistrées à partir desquelles les coefficients d'échelle et de décalage sont obtenus, cette mise à jour étant réalisée à partir du deuxième vecteur brute, du vecteur de référence et de la nouvelle estimation de l'orientation du véhicule de manière à réduire l'écart entre les composantes corrigées du deuxième vecteur de mesure et les composantes du vecteur de référence lorsque toutes ces composantes sont exprimées dans un repère commun.

2. Procédé selon la revendication 1, dans lequel la phase de calibration comporte :

- le calcul (104) d'un écart entre les composantes brutes du deuxième vecteur de mesure et une estimation de ces composantes obtenues à partir du vecteur de référence et de l'estimation de l'orientation du véhicule, puis
- la comparaison (82) de l'écart calculé à un deuxième seuil prédéterminé, puis
- lorsque l'écart calculé dépasse ce deuxième seuil, l'opération 3) est inhibée et, lorsque l'écart calculé ne dépasse pas ce deuxième seuil, l'opération 3) est autorisée.

3. Procédé selon la revendication 1 ou 2, dans lequel la phase de calibration comporte le calcul (104) de l'écart-type de l'écart calculé et la comparaison (82) de l'écart calculé, pondéré en fonction de cette écart-type calculé, au deuxième seuil.

4. Procédé selon l'une quelconque des revendications précédentes, dans lequel la phase de calibration comporte :

- le calcul d'un écart d'orientation entre l'orientation du véhicule lors d'une précédente exécution de la phase de calibration et l'orientation du véhicule lors de la présente exécution de la phase de calibration, puis
- la comparaison (82) de l'écart d'orientation calculé à un troisième seuil prédéterminé, puis
- lorsque l'écart d'orientation calculé ne dépasse pas ce troisième seuil, l'opération 3) est inhibée et, lorsque l'écart d'orientation calculé dépasse ce troisième seuil, l'opération 3) est autorisée.

5. Procédé selon l'une quelconque des revendications précédentes, dans lequel l'obtention (58) du vecteur de référence comporte le calcul des composantes du vecteur de référence à partir :

- de l'estimation de la position du véhicule, et
- d'un modèle pré-enregistrée du champ géomagnétique qui associe, à chaque position possible du véhicule, les composantes du champ géomagnétique à cette position dans le repère terrestre, ce modèle intégrant à cet effet des variations locales du champ géomagnétique.

6. Procédé selon l'une quelconque des revendications précédentes, dans lequel la phase de calibration comporte :

- l'établissement (84) de nouvelles valeurs pour les données pré-enregistrées à partir desquelles les coefficients d'échelle et de décalage sont obtenus, ces nouvelles valeurs étant calculées à partir des composantes brutes du deuxième vecteur de mesure, du vecteur de référence et de l'orientation estimée du véhicule, et l'établissement de ces nouvelles valeurs pour les données pré-enregistrées comportant également le calcul (102) d'au moins une marge d'erreur sur une de ces nouvelles valeurs calculées, puis
- la comparaison (86) de cette marge d'erreur calculée à un quatrième seuil prédéterminé, puis
- lorsque la marge d'erreur calculée dépasse ce quatrième seuil, l'utilisation des nouvelles valeurs calculées pour calculer des coefficients d'échelle et de décalage est inhibée et, lorsque la marge d'erreur calculée ne dépasse pas ce quatrième seuil :

• l'opération 3) est autorisée et les données pré-enregistrées mises à jour sont prises égales aux nouvelles valeurs calculées, et
• l'utilisation des nouvelles valeurs calculées pour calculer des coefficients d'échelle et de décalage est autorisée.

7. Procédé selon l'une quelconque des revendications précédentes, dans lequel la phase de calibration comporte :

- l'établissement (104), à partir de l'estimation de l'orientation du véhicule, des composantes d'une matrice de rotation qui permet de réaliser un changement de repère depuis le repère terrestre vers le repère mobile,
- la multiplication (104) du vecteur de référence par la matrice de rotation pour obtenir le vecteur de référence dont les composantes sont exprimées dans le repère mobile, ce repère mobile formant alors le repère commun.

8.  Procédé selon l'une quelconque des revendications précédentes, dans lequel la phase de calibration comporte :

    - la comparaison (82) de la marge d'erreur sur l'estimation de l'orientation au premier seuil, puis
    - lorsque la marge d'erreur sur l'estimation de l'orientation dépasse ce premier seuil, l'opération 3) est inhibée et, lorsque la marge d'erreur sur l'estimation de l'orientation ne dépasse pas ce premier seuil, l'opération 3) est autorisée.

9.  Support (24) d'enregistrement d'informations, lisible par un microprocesseur, **caractérisé en ce que** ce support comporte des instructions pour la réalisation de la phase de calibration d'un magnétomètre d'un procédé de détermination de la position et de l'orientation d'un véhicule conforme à l'une quelconque des revendications précédentes, lorsque ces instructions sont exécutées par le microprocesseur.

10. Système (6) de localisation, apte à être fixé sur un véhicule, pour déterminer la position et l'orientation de ce véhicule, ce système de localisation comportant :

    - une unité (10) de géolocalisation par satellite,
    - une unité (12) de navigation inertielle contenant un accéléromètre (14) et un gyromètre (16), et
    - un magnétomètre (30) comportant au moins deux axes de mesure,
    ce système de localisation étant configuré pour :
    - mesurer, à l'aide du magnétomètre (30), un premier vecteur de mesures brutes contenant une composante brute pour chacun des axes de mesure, chaque composante codant l'amplitude et la direction de la projection orthogonale du champ magnétique qui traverse ce magnétomètre sur un axe respectif de mesure, ces axes de mesure étant fixes dans un repère mobile tri-axe fixé sur le véhicule, puis
    - corriger chacune des composantes brutes du premier vecteur en la multipliant par un coefficient d'échelle et en y ajoutant un coefficient de décalage pour obtenir une composante corrigée, ces coefficients d'échelle et de décalage étant obtenus à partir de données pré-enregistrées dans une mémoire du système de localisation, puis
    - construire une estimation initiale de l'angle de lacet du véhicule à partir des composantes corrigées du premier vecteur, puis
    - initialiser, à l'aide de l'estimation initiale de l'angle de lacet, un algorithme de fusion apte à établir, à partir de précédentes estimations de la position et de l'orientation du véhicule et en utilisant à la fois les mesures de l'unité de géolocalisation et les mesures de l'unité de navigation inertielle réalisées depuis ces précédentes estimations :

        • de nouvelles estimations de la position et de l'orientation du véhicule, et
        • une marge d'erreur sur cette nouvelle estimation de l'orientation du véhicule, puis

    - exécuter de façon répétée (74) cet algorithme de fusion pour mettre à jour en continu l'estimation de la position et de l'orientation du véhicule,
    **caractérisé en ce que** le système comporte un module (36) de calibration apte, après le début de l'exécution répétée de l'algorithme de fusion et en parallèle de l'exécution répétée de l'algorithme de fusion, à exécuter les opérations suivantes :

        1) l'acquisition de la mesure, par le magnétomètre, d'un deuxième vecteur de mesures brutes,
        2) l'obtention d'un vecteur de référence comportant une composante pour chaque axe de mesure, chacune de ces composantes codant l'amplitude et la direction de la projection orthogonale du champ géomagnétique qui traverse le magnétomètre sur un axe respectif d'un repère terrestre tri-axe fixé sans aucun degré de liberté à la terre, les composantes du vecteur de référence étant obtenues à partir d'un modèle pré-enregistré du champ géomagnétique et non pas mesurées par le magnétomètre, puis
        3) uniquement lorsque la marge d'erreur sur l'estimation de l'orientation du véhicule tombe en dessous d'un premier seuil prédéterminé, la mise à jour des données pré-enregistrées à partir desquelles les coefficients d'échelle et de décalage sont obtenus, cette mise à jour étant réalisée à partir du deuxième vecteur brute, du vecteur de référence et de la nouvelle estimation de l'orientation du véhicule de manière à réduire l'écart entre les composantes corrigées du deuxième vecteur de mesure et les composantes du vecteur de référence lorsque toutes ces composantes sont exprimées dans un repère commun.

**Patentansprüche**

1. Verfahren zur Bestimmung der Position und der Orientierung eines Fahrzeugs, wobei dieses Verfahren Folgendes umfasst:

- Bereitstellen eines Lokalisierungssystems, das in diesem Fahrzeug installiert ist, wobei dieses Lokalisierungssystem Folgendes umfasst:

   • eine satellitengestützte Geolokalisierungseinheit,
   • eine Trägheitsnavigationseinheit, die einen Beschleunigungsmesser und ein Gyrometer enthält, und
   • ein Magnetometer, das mindestens zwei Messachsen umfasst,

- Messen (52), durch das Magnetometer, eines ersten Rohmessungsvektors, der für jede der Messachsen eine Rohkomponente enthält, wobei jede Komponente die Amplitude und die Richtung der orthogonalen Projektion des Magnetfelds, das auf einer jeweiligen Messachse durch dieses Magnetometer verläuft, kodiert, wobei diese Messachsen in einem mit dem Fahrzeug verbundenen dreiachsigen mobilen Bezugssystem fest sind, und dann
- Korrigieren (54) jeder der Rohkomponenten des ersten Vektors durch Multiplikation mit einem Skalierungskoeffizienten und durch Addition eines Verschiebungskoeffizienten, um eine korrigierte Komponente zu erhalten, wobei diese Skalierungs- und Verschiebungskoeffizienten anhand von Daten erhalten werden, die im Vorfeld in einem Speicher des Lokalisierungssystems aufgezeichnet werden, dann
- erstes Schätzen (60) des Gierwinkels des Fahrzeugs anhand der korrigierten Komponenten des ersten Vektors, dann
- Initialisieren (72), mit Hilfe der ersten Schätzung des Gierwinkels, eines Fusionsalgorithmus, der dazu fähig ist, anhand von vorhergehenden Schätzungen der Position und der Orientierung des Fahrzeugs und unter gleichzeitiger Verwendung der Messungen der Geolokalisierungseinheit und der Messungen der Trägheitsnavigationseinheit, die seit diesen vorhergehenden Schätzungen durchgeführt wurden, Folgendes zu erstellen:

   • neue Schätzungen der Position und der Orientierung des Fahrzeugs und
   • eine Fehlerspanne in Bezug auf diese neue Schätzung der Orientierung des Fahrzeugs, dann

- wiederholtes Ausführen (74) dieses Fusionsalgorithmus, um die Schätzung der Position und der Orientierung des Fahrzeugs laufend zu aktualisieren,
**dadurch gekennzeichnet, dass** nach dem Start des wiederholten Ausführens des Fusionsalgorithmus und parallel zu dem wiederholten Ausführen des Fusionsalgorithmus das Verfahren eine Kalibrierphase (80) umfasst, die die folgenden Operationen umfasst:

   1) Messen (81), durch das Magnetometer, eines zweiten Rohmessungsvektors,
   2) Erhalten (84) eines Referenzvektors, der für jede Messachse eine Komponente umfasst, wobei jede dieser Komponenten die Amplitude und die Richtung der orthogonalen Projektion des Geomagnetfelds, das auf einer jeweiligen Achse eines dreiachsigen terrestrischen Bezugssystems, das ohne Freiheitsgrad mit der Erde verbunden ist, verläuft, kodiert, wobei die Komponenten des Referenzvektors anhand eines im Vorfeld aufgezeichneten Modells des Geomagnetfelds erhalten werden und nicht durch das Magnetometer gemessen werden, dann
   3) nur, wenn die Fehlerspanne in Bezug auf die Schätzung der Orientierung des Fahrzeugs einen ersten vorgegebenen Schwellenwert unterschreitet, Aktualisieren (84) der im Vorfeld aufgezeichneten Daten, anhand derer die Skalierungs- und Verschiebungskoeffizienten erhalten werden, wobei dieses Aktualisieren anhand des zweiten Rohvektors, des Referenzvektors und der neuen Schätzung der Orientierung des Fahrzeugs durchgeführt wird, um die Abweichung zwischen den korrigierten Komponenten des zweiten Messvektors und den Komponenten des Referenzvektors zu verringern, wenn all diese Komponenten in einem gemeinsamen Bezugssystem dargestellt werden.

2. Verfahren nach Anspruch 1, wobei die Kalibrierphase Folgendes umfasst:

- Berechnen (104) einer Abweichung zwischen den Rohkomponenten des zweiten Messvektors und einer Schätzung dieser Komponenten, die anhand des Referenzvektors und der Schätzung der Orientierung des Fahrzeugs erhalten wurden, dann
- Vergleichen (82) der berechneten Abweichung mit einem zweiten vorgegebenen Schwellenwert, dann
- wenn die berechnete Abweichung diesen zweiten Schwellenwert überschreitet, die Operation 3) verhindert wird, und wenn die berechnete Abweichung diesen zweiten Schwellenwert nicht überschreitet, die Operation 3) zugelassen wird.

3. Verfahren nach Anspruch 1 oder 2, wobei die Kalibrierphase das Berechnen (104) des Abweichungstyps der berechneten Abweichung und das Vergleichen (82) der in Abhängigkeit von diesem berechneten Abweichungstyp gewichteten berechneten Abweichung mit dem zweiten Schwellenwert umfasst.

4. Verfahren nach einem der vorhergehenden Ansprüche, wobei die Kalibrierphase Folgendes umfasst:

   - Berechnen einer Orientierungsabweichung zwischen der Orientierung des Fahrzeugs während einer vorhergehenden Ausführung der Kalibrierphase und der Orientierung des Fahrzeugs während der aktuellen Ausführung der Kalibrierphase, dann
   - Vergleichen (82) der berechneten Orientierungsabweichung mit einem dritten vorgegebenen Schwellenwert, dann
   - wenn die berechnete Orientierungsabweichung diesen dritten Schwellenwert nicht überschreitet, die Operation 3) verhindert wird, und wenn die berechnete Orientierungsabweichung diesen dritten Schwellenwert überschreitet, die Operation 3) zugelassen wird.

5. Verfahren nach einem der vorhergehenden Ansprüche, wobei das Erhalten (58) des Referenzvektors das Berechnen der Komponenten des Referenzvektors anhand von Folgendem umfasst:

   - der Schätzung der Position des Fahrzeugs und
   - eines im Vorfeld aufgezeichneten Modells des Geomagnetfelds, das jeder möglichen Position des Fahrzeugs die Komponenten des Geomagnetfelds an dieser Position in dem terrestrischen Bezugssystem zuordnet, wobei dieses Modell zu diesem Zweck lokale Schwankungen des Geomagnetfelds einbezieht.

6. Verfahren nach einem der vorhergehenden Ansprüche, wobei die Kalibrierphase Folgendes umfasst:

   - Erstellen (84) neuer Werte für die im Vorfeld aufgezeichneten Daten, anhand derer die Skalierungs- und Verschiebungskoeffizienten erhalten werden, wobei diese neuen Werte anhand der Rohkomponenten des zweiten Messvektors, des Referenzvektors und der geschätzten Orientierung des Fahrzeugs berechnet werden und wobei das Erstellen dieser neuen Werte für die im Vorfeld aufgezeichneten Daten ferner das Berechnen (102) mindestens einer Fehlerspanne in Bezug auf einen dieser neuen berechneten Werte umfasst, dann
   - Vergleichen (86) dieser berechneten Fehlerspanne mit einem vierten vorgegebenen Schwellenwert, dann
   - wenn die berechnete Fehlerspanne diesen vierten Schwellenwert überschreitet, die Verwendung der neuen berechneten Werte für das Berechnen von Skalierungs- und Verschiebungskoeffizienten verhindert wird, und wenn die berechnete Fehlerspanne diesen vierten Schwellenwert nicht überschreitet:

     • die Operation 3) zugelassen wird und die aktualisierten im Vorfeld aufgezeichneten Daten den neuen berechneten Werten gleichgesetzt werden und
     • die Verwendung der neuen berechneten Werte, um Skalierungs- und Verschiebungskoeffizienten zu berechnen, zugelassen wird.

7. Verfahren nach einem der vorhergehenden Ansprüche, wobei die Kalibrierphase Folgendes umfasst:

   - Erstellen (104), anhand der Schätzung der Orientierung des Fahrzeugs, der Komponenten einer Drehmatrix, die es gestattet, einen Bezugssystemwechsel von dem terrestrischen Bezugssystem zu dem mobilen Bezugssystem durchzuführen,
   - Multiplizieren (104) des Referenzvektors mit der Drehmatrix, um den Referenzvektor zu erhalten, dessen Komponenten in dem mobilen Bezugssystem dargestellt sind, wobei dieses mobile Bezugssystem somit das gemeinsame Bezugssystem bildet.

8. Verfahren nach einem der vorhergehenden Ansprüche, wobei die Kalibrierphase Folgendes umfasst:

   - Vergleichen (82) der Fehlerspanne in Bezug auf die Schätzung der Orientierung mit dem ersten Schwellenwert, dann
   - wenn die Fehlerspanne in Bezug auf die Schätzung der Orientierung diesen ersten Schwellenwert überschreitet, die Operation 3) verhindert wird, und wenn die Fehlerspanne in Bezug auf die Schätzung der Orientierung diesen ersten Schwellenwert nicht überschreitet, die Operation 3) zugelassen wird.

9. Informationsaufzeichnungsträger (24), der von einem Mikroprozessor gelesen werden kann, **dadurch gekennzeichnet, dass** dieser Träger Anweisungen für die Durchführung der Kalibrierphase eines Magnetometers eines Verfahrens zur Bestimmung der Position und der Orientierung eines Fahrzeugs nach einem der vorhergehenden Ansprüche umfasst, wenn diese Anweisungen durch den Mikroprozessor ausgeführt werden.

10. Lokalisierungssystem (6), das dazu fähig ist, in einem Fahrzeug installiert zu sein, um die Position und die Orientierung dieses Fahrzeugs zu bestimmen, wobei dieses Lokalisierungssystem Folgendes umfasst:

- eine satellitengestützte Geolokalisierungseinheit (10),
- eine Trägheitsnavigationseinheit (12), die einen Beschleunigungsmesser (14) und ein Gyrometer (16) enthält, und
- ein Magnetometer (30), das mindestens zwei Messachsen umfasst,
wobei dieses Lokalisierungssystem zu Folgendem konfiguriert ist:
- Messen, mit Hilfe des Magnetometers (30), eines ersten Rohmessungsvektors, der für jede der Messachsen eine Rohkomponente enthält, wobei jede Komponente die Amplitude und die Richtung der orthogonalen Projektion des Magnetfelds, das auf einer jeweiligen Messachse durch dieses Magnetometer verläuft, kodiert, wobei diese Messachsen in einem mit dem Fahrzeug verbundenen dreiachsigen mobilen Bezugssystem fest sind, dann
- Korrigieren jeder der Rohkomponenten des ersten Vektors durch Multiplikation mit einem Skalierungskoeffizienten und durch Addition eines Verschiebungskoeffizienten, um eine korrigierte Komponente zu erhalten, wobei diese Skalierungs- und Verschiebungskoeffizienten anhand von Daten erhalten werden, die im Vorfeld in einem Speicher des Lokalisierungssystems aufgezeichnet werden, dann
- Konstruieren einer ersten Schätzung des Gierwinkels des Fahrzeugs anhand der korrigierten Komponenten des ersten Vektors, dann
- Initialisieren, mit Hilfe der ersten Schätzung des Gierwinkels, eines Fusionsalgorithmus, der dazu fähig ist, anhand von vorhergehenden Schätzungen der Position und der Orientierung des Fahrzeugs und unter gleichzeitiger Verwendung der Messungen der Geolokalisierungseinheit und der Messungen der Trägheitsnavigationseinheit, die seit diesen vorhergehenden Schätzungen durchgeführt wurden, Folgendes zu erstellen:

• neue Schätzungen der Position und der Orientierung des Fahrzeugs und
• eine Fehlerspanne in Bezug auf diese neue Schätzung der Orientierung des Fahrzeugs, dann

- wiederholtes Ausführen (74) dieses Fusionsalgorithmus, um die Schätzung der Position und der Orientierung des Fahrzeugs laufend zu aktualisieren,
**dadurch gekennzeichnet, dass** das System ein Kalibriermodul (36) umfasst, das dazu fähig ist, nach dem Start des wiederholten Ausführens des Fusionsalgorithmus und parallel zu dem wiederholten Ausführen des Fusionsalgorithmus die folgenden Operationen auszuführen:

1) Erfassen der Messung, durch das Magnetometer, eines zweiten Rohmessungsvektors,
2) Erhalten eines Referenzvektors, der für jede Messachse eine Komponente umfasst, wobei jede dieser Komponenten die Amplitude und die Richtung der orthogonalen Projektion des Geomagnetfelds, das auf einer jeweiligen Achse eines dreiachsigen terrestrischen Bezugssystems, das ohne Freiheitsgrad mit der Erde verbunden ist, verläuft, kodiert, wobei die Komponenten des Referenzvektors anhand eines im Vorfeld aufgezeichneten Modells des Geomagnetfelds erhalten werden und nicht durch das Magnetometer gemessen werden, dann
3) nur, wenn die Fehlerspanne in Bezug auf die Schätzung der Orientierung des Fahrzeugs einen ersten vorgegebenen Schwellenwert unterschreitet, Aktualisieren der im Vorfeld aufgezeichneten Daten, anhand derer die Skalierungs- und Verschiebungskoeffizienten erhalten werden, wobei dieses Aktualisieren anhand des zweiten Rohvektors, des Referenzvektors und der neuen Schätzung der Orientierung des Fahrzeugs durchgeführt wird, um die Abweichung zwischen den korrigierten Komponenten des zweiten Messvektors und den Komponenten des Referenzvektors zu verringern, wenn all diese Komponenten in einem gemeinsamen Bezugssystem dargestellt werden.

**Claims**

1. Method for determining the position and orientation of a vehicle, this method including:

   - providing a location system fixed to this vehicle, this location system including:

     • a satellite geolocation unit;
     • an inertial navigation unit containing an accelerometer and a gyrometer; and
     • a magnetometer including at least two measurement axes;

   - measuring (52), by means of the magnetometer, a first raw-measurement vector containing a raw component for each of the measurement axes, each component encoding the amplitude and the direction of the orthogonal projection of the magnetic field which passes through this magnetometer on a respective measurement axis, these measurement axes being fixed in a triaxial moving reference frame fixed to the vehicle; then
   - correcting (54) each of the raw components of the first vector by multiplying the component by a scale coefficient and by adding an offset coefficient thereto to obtain a corrected component, these scale and offset coefficients being obtained from pre-recorded data in a memory of the location system; then
   - initially estimating (60) the yaw angle of the vehicle on the basis of the corrected components of the first vector; then
   - initializing (72), using the initial estimate of the yaw angle, a merge algorithm capable of establishing, on the basis of preceding estimates of the position and of the orientation of the vehicle and by using both the measurements from the geolocation unit and the measurements from the inertial navigation unit taken since these preceding estimates:

     • new estimates of the position and of the orientation of the vehicle; and
     • a margin of error in this new estimate of the orientation of the vehicle; then

   - repeatedly running (74) this merge algorithm to continuously update the estimate of the position and of the orientation of the vehicle,
   **characterized in that**, after the start of the repeated running of the merge algorithm and in parallel to the repeated running of the merge algorithm, the method includes a calibration phase (80) including the following operations:

     1) measuring (81), by means of the magnetometer, a second raw-measurement vector;
     2) obtaining (84) a reference vector including a component for each measurement axis, each of these components encoding the amplitude and the direction of the orthogonal projection of the geomagnetic field which passes through the magnetometer on a respective axis of a fixed triaxial terrestrial reference frame with no degree of freedom with respect to the earth, the components of the reference vector being obtained from a pre-recorded model of the geomagnetic field and not measured by the magnetometer; then
     3) only if the margin of error in the estimate of the orientation of the vehicle is below a first predetermined threshold, updating (84) the pre-recorded data from which the scale and offset coefficients are obtained, this update being performed using the second raw vector, the reference vector and the new estimate of the orientation of the vehicle so as to decrease the difference between the corrected components of the second measurement vector and the components of the reference vector when all of these components are expressed in a common reference frame.

2. Method according to Claim 1, wherein the calibration phase includes:

   - calculating (104) a difference between the raw components of the second measurement vector and an estimate of these components which are obtained from the reference vector and from the estimate of the orientation of the vehicle; then
   - comparing (82) the calculated difference with a second predetermined threshold; then
   - if the calculated difference exceeds this second threshold, operation 3) is put on hold and, once the calculated difference does not exceed this second threshold, operation 3) is allowed to go ahead.

3. Method according to Claim 1 or 2, wherein the calibration phase includes calculating (104) the standard deviation of the calculated difference and comparing (82) the calculated difference, weighted according to this calculated standard deviation, with the second threshold.

4. Method according to any one of the preceding claims, wherein the calibration phase includes:

- calculating a difference in orientation between the orientation of the vehicle in a preceding execution of the calibration phase and the orientation of the vehicle in the present execution of the calibration phase; then
- comparing (82) the calculated difference in orientation with a third predetermined threshold; then
- if the calculated difference in orientation does not exceed this third threshold, operation 3) is put on hold and, once the calculated difference in orientation does exceed this third threshold, operation 3) is allowed to go ahead.

5. Method according to any one of the preceding claims, wherein obtaining (58) the reference vector includes calculating the components of the reference vector from:

- the estimate of the position of the vehicle; and
- a pre-recorded model of the geomagnetic field which associates, with each possible position of the vehicle, the components of the geomagnetic field at this position in the terrestrial reference frame, this model incorporating local variations in the geomagnetic field to this end.

6. Method according to any one of the preceding claims, wherein the calibration phase includes:

- establishing (84) new values for the pre-recorded data from which the scale and offset coefficients are obtained, these new values being calculated on the basis of the raw components of the second measurement vector, of the reference vector and of the estimated orientation of the vehicle, and establishing these new values for the pre-recorded data also including the calculation (102) of at least one margin of error in one of these calculated new values; then
- comparing (86) this calculated margin of error with a fourth predetermined threshold; then
- if the calculated margin of error exceeds this fourth threshold, the use of the calculated new values to calculate scale and offset coefficients is put on hold and, once the calculated margin of error does not exceed this fourth threshold:

• operation 3) is allowed to go ahead and the updated pre-recorded data are taken as equal to the calculated new values; and
• using the calculated new values to calculate scale and offset coefficients is allowed to go ahead.

7. Method according to any one of the preceding claims, wherein the calibration phase includes:

- establishing (104), on the basis of the estimate of the orientation of the vehicle, the components of a rotation matrix which allows a change in reference frame from the terrestrial reference frame to the moving reference frame;
- multiplying (104) the reference vector by the rotation matrix to obtain the reference vector the components of which are expressed in the moving reference frame, this moving reference frame then forming the common reference frame.

8. Method according to any one of the preceding claims, wherein the calibration phase includes:

- comparing (82) the margin of error in the estimate of the orientation with the first threshold; then
- if the margin of error in the estimate of the orientation exceeds this first threshold, operation 3) is put on hold and, once the margin of error in the estimate of the orientation does not exceed this first threshold, operation 3) is allowed to go ahead.

9. Information storage medium (24), readable by a microprocessor, **characterized in that** this medium includes instructions for carrying out the phase of calibrating a magnetometer of a method for determining the position and orientation of a vehicle according to any one of the preceding claims, when these instructions are executed by the microprocessor.

10. Location system (6), suitable for being fixed to a vehicle, for determining the position and orientation of this vehicle, this location system including:

- a satellite geolocation unit (10);
- an inertial navigation unit (12) containing an accelerometer (14) and a gyrometer (16); and
- a magnetometer (30) including at least two measurement axes;
this location system being configured:
- to measure, by means of the magnetometer (30), a first raw-measurement vector containing a raw component for each of the measurement axes, each component encoding the amplitude and the direction of the orthogonal projection of the magnetic field which passes through this magnetometer on a respective measurement axis, these measurement axes being fixed in a triaxial moving reference frame fixed to the vehicle; then
- to correct each of the raw components of the first vector by multiplying the component by a scale coefficient and by adding an offset coefficient thereto to obtain a corrected component, these scale and offset coefficients being obtained from pre-recorded data in a memory of the location system; then
- to produce an initial estimate of the yaw angle of the vehicle on the basis of the corrected components of the first vector; then
- to initialize, using the initial estimate of the yaw angle, a merge algorithm capable of establishing, on the basis of preceding estimates of the position and of the orientation of the vehicle and by using both the measurements from the geolocation unit and the measurements from the inertial navigation unit taken since these preceding estimates:

  • new estimates of the position and of the orientation of the vehicle; and
  • a margin of error in this new estimate of the orientation of the vehicle; then

- to run (74) this merge algorithm repeatedly to continuously update the estimate of the position and of the orientation of the vehicle,
**characterized in that** the system includes a calibration module (36) capable, after the start of the repeated running of the merge algorithm and in parallel to the repeated running of the merge algorithm, of carrying out the following operations:

  1) acquiring the measurement, by means of the magnetometer, of a second raw-measurement vector;
  2) obtaining a reference vector including a component for each measurement axis, each of these components encoding the amplitude and the direction of the orthogonal projection of the magnetic field which passes through the magnetometer on a respective axis of a fixed triaxial terrestrial reference frame with no degree of freedom with respect to the earth, the components of the reference vector being obtained from a pre-recorded model of the geomagnetic field and not measured by the magnetometer; then
  3) only if the margin of error in the estimate of the orientation of the vehicle is below a first predetermined threshold, updating the pre-recorded data from which the scale and offset coefficients are obtained, this update being performed using the second raw vector, the reference vector and the new estimate of the orientation of the vehicle so as to decrease the difference between the corrected components of the second measurement vector and the components of the reference vector when all of these components are expressed in a common reference frame.

Fig. 1

Fig. 2

Fig. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1719975 A1
- WO 2014134710 A1
- US 2011238307 A1
- EP 3276302 A1

**Littérature non-brevet citée dans la description**

- Principles of GNSS, Inertial, and Multisensor Integrated Navigation Systems. **PAUL D. GROVES.** GNSS Technology and Applications. Artech House, 2008